# EUROPÄISCHE PATENTSCHRIFT

(11) **EP 1 153 481 B1**
(45) Veröffentlichungstag und Bekanntmachung des Hinweises auf die Patenterteilung: **24.07.2002**
(21) Anmeldenummer: 00901575.1
(22) Anmeldetag: 17.01.2000
(51) Int. Cl.: H03M 7/40, H04B 1/66

(54) **VERFAHREN UND VORRICHTUNG ZUM ERZEUGEN EINES DATENSTROMS AUS CODEWORTEN VARIABLER LÄNGE UND VERFAHREN UND VORRICHTUNG ZUM LESEN EINES DATENSTROMS AUS CODEWORTEN VARIABLER LÄNGE**
METHOD AND DEVICE FOR GENERATING A DATA FLOW FROM VARIABLE-LENGTH CODE WORDS AND A METHOD AND DEVICE FOR READING A DATA FLOW FROM VARIABLE-LENGTH CODE WORDS
PROCEDE ET DISPOSITIF POUR PRODUIRE UN FLUX DE DONNEES CONSTITUE DE MOTS DE CODE DE LONGUEUR VARIABLE, ET PROCEDE ET DISPOSITIF POUR LIRE UN FLUX DE DONNEES CONSTITUE DE MOTS DE CODE DE LONGUEUR VARIABLE

(30) Priorität: 23.02.1999 DE 19907729
(43) Veröffentlichungstag der Anmeldung: 14.11.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: SPERSCHNEIDER, Ralph, D-91056 Erlangen (DE); DIETZ, Martin, D-90429 Nürnberg (DE); LAUBER, Pierre, D-90419 Nürnberg (DE); SCHUG, Michael, D-91056 Erlangen (DE)
(74) Vertreter: Schoppe, Fritz, Dipl.-Ing.
(86) Internationale Anmeldenummer: EP0000312
(87) Internationale Veröffentlichungsnummer: WO0051241

(56) Entgegenhaltungen:
- EP-A- 0 453 229
- EP-A- 0 612 156
- EP-A- 0 732 855
- DE-A- 19 747 119
- US-A- 5 392 037
- US-A- 5 579 430
- TAKISHIMA T ET AL: "REVERSIBLE VARIABLE LENGTH CODES" IEEE TRANSACTIONS ON COMMUNICATIONS,US,IEEE INC. NEW YORK, Bd. 43, Nr. 2/04, PART 01, 1. Februar 1995 (1995-02-01), Seiten 158-162, XP000506544 ISSN: 0090-6778
- "Resynchronizing Variable-Length Codes for Robust Image Transmission" Authors : Sheila S. HEMAMI, Tader CHANG, Richard LAU IEEE 1999 ISSN : 1068-0314 XP002137338
- "Reversible Variable Length Codes (RVLC) for robust coding of 3D topological mesh data" Authors : Zhidong YAN, Sunil KUMAR, Jiankun LI and C.C. Jay KUO IEEE 1999 ISSN : 1068-0314 XP002137339

## Beschreibung

Die vorliegende Erfindung bezieht sich auf das Codieren mit Codeworten variabler Länge und insbesondere auf das Erzeugen und Lesen von Datenströmen mit Codeworten variabler Länge, die gegen Fehler bei der Übertragung robust sind.

Moderne Audiocodierverfahren bzw. -decodierverfahren, die beispielsweise nach dem Standard MPEG-Layer 3 arbeiten, sind in der Lage, die Datenrate von Audiosignalen beispielsweise um einen Faktor 12 zu komprimieren, ohne die Qualität derselben merkbar zu verschlechtern. Um eine derartig hohe Datenratenreduktion zu erreichen, wird ein Audiosignal abgetastet, wodurch eine Folge von zeitdiskreten Abtastwerten erhalten wird. Wie es in der Technik bekannt ist, wird diese Folge von zeitdiskreten Abtastwerten mittels geeigneter Fensterfunktionen gefenstert, um gefensterte Blöcke von zeitlichen Abtastwerten zu erhalten. Ein Block zeitlich gefensterter Abtastwerte wird dann mittels einer Filterbank, einer modifizierten diskreten Cosinustransformation (MDCT) oder einer anderen geeigneten Einrichtung in den Frequenzbereich transformiert, um Spektralwerte zu erhalten, die insgesamt das Audiosignal, d. h. den zeitlichen Ausschnitt, der durch den Block von zeitdiskreten Abtastwerten gegeben ist, im Frequenzbereich darstellen. Üblicherweise werden sich zu 50% überlappende zeitliche Blöcke erzeugt und mittels einer MDCT in den Frequenzbereich transformiert, wodurch aufgrund der speziellen Eigenschaften der MDCT immer beispielsweise 1024 zeitdiskrete Abtastwerte zu 1024 Spektralwerten führen.

Es ist bekannt, daß die Aufnahmefähigkeit des menschlichen Ohrs vom Augenblicksspektrum des Audiosignals selbst abhängt. Diese Abhängigkeit ist in dem sog. psychoakustischen Modell erfaßt, mittels dem es seit längerem möglich ist, abhängig vom augenblicklichen Spektrum Maskierungsschwellen zu berechnen. Maskierung bedeutet, daß ein bestimmter Ton bzw. Spektralanteil verdeckt wird, wenn beispielsweise ein benachbarter Spektralbereich eine relativ hohe Energie besitzt. Diese Tatsache der Maskierung wird ausgenutzt, um die nach der Transformation vorhandenen Spektralwerte möglichst grob zu quantisieren. Es wird daher angestrebt, einerseits hörbare Störungen im wieder decodierten Audiosignal zu vermeiden und andererseits möglichst wenig Bits zu verwenden, um das Audiosignal zu codieren bzw. hier zu quantisieren. Die durch die Quantisierung eingeführten Störungen, d. h. das Quantisierungsrauschen, soll unter der Maskierungsschwelle liegen und somit unhörbar sein. Gemäß bekannter Verfahren wird daher eine Einteilung der Spektralwerte in sog. Skalenfaktorbänder durchgeführt, die den Frequenzgruppen des menschlichen Ohrs entsprechen sollten. Spektralwerte in einer Skalenfaktorgruppe werden mit einem Skalenfaktor multipliziert, um Spektralwerte eines Skalenfaktorbandes insgesamt zu skalieren. Die durch den Skalenfaktor skalierten Skalenfaktorbänder werden anschließend quantisiert, woraufhin quantisierte Spektralwerte entstehen. Selbstverständlich ist eine Gruppierung in Skalenfaktorbänder nicht entscheidend. Sie wird jedoch bei den Standards MPEG-Layer 3 bzw. bei dem Standard MPEG-2 AAC (AAC = Advanced Audio Coding) verwendet.

Ein sehr wesentlicher Aspekt der Datenreduzierung besteht in der nach dem Quantisieren folgenden Entropie-Codierung der quantisierten Spektralwerte. Für die Entropiecodierung wird üblicherweise eine Huffman-Codierung verwendet. Unter einer Huffman-Codierung versteht man eine Codierung mit variabler Länge, d. h. die Länge des Codeworts für einen zu codierenden Wert ist abhängig von dessen Auftrittswahrscheinlichkeit. Logischerweise ordnet man dem wahrscheinlichsten Zeichen den kürzesten Code, d. h. das kürzeste Codewort, zu, so daß mit der Huffman-Codierung eine sehr gute Redundanzreduktion erreicht werden kann. Ein Beispiel für eine allseits bekannte Codierung mit allgemeiner Länge ist das Morse-Alphabet.

In der Audiocodierung werden Huffman-Codes zur Codierung der quantisierten Spektralwerte benutzt. Ein moderner Audio-Coder, der beispielsweise nach dem Standard MPEG-2 AAC arbeitet, verwendet zur Codierung der quantisierten Spektralwerte verschiedene Huffman-Codetabellen, die dem Spektrum nach bestimmten Kriterien abschnittsweise zugeordnet werden. Dabei werden immer 2 oder 4 Spektralwerte in einem Codewort gemeinsam codiert.

Ein Unterschied des Verfahrens nach MPEG-2 AAC gegenüber dem Verfahren MPEG-Layer 3 besteht nun darin, daß verschiedene Skalenfaktorbänder, d. h. verschiedene Spektralwerte, zu beliebig vielen Spektralabschnitten oder "sections" gruppiert werden. Bei AAC umfaßt ein Spektralabschnitt oder eine "Section" umfaßt zumindest vier Spektralwerte aber vorzugsweise mehr als vier Spektralwerte. Der gesamte Frequenzbereich der Spektralwerte wird daher in benachbarte Sections aufgeteilt, wobei eine Section ein Frequenzband darstellt, derart, daß alle Sections zusammen den gesamten Frequenzbereich, der durch die Spektralwerte nach der Transformation derselben überdeckt wird, umfassen.

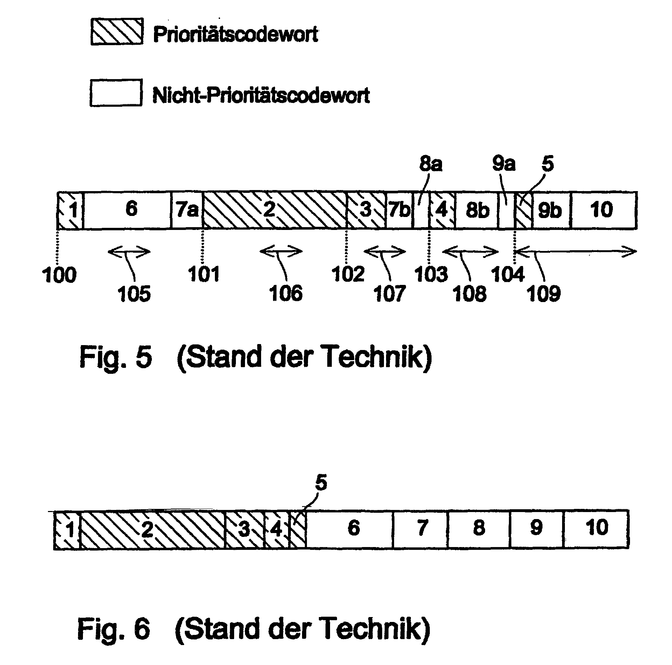

Einem Abschnitt wird nun ebenso wie beim MPEG-Layer-3-Verfahren zum Erreichen einer maximalen Redundanzreduktion eine sog. Huffman Tabelle aus einer Mehrzahl derartiger Tabellen zugeordnet. Im Bitstrom des AAC-Verfahrens, welches üblicherweise 1024 Spektralwerte aufweist, befinden sich nun die Huffman-Codewörter für die Spektralwerte in aufsteigender Frequenzreihenfolge. Die Information über die in jedem Frequenzabschnitt verwendete Tabelle wird in den Seiteninformationen übertragen. Diese Situation ist in Fig. 6 dargestellt.

Fig. 6 stellt den beispielhaften Fall dar, bei dem der Bitstrom 10 Huffman-Codeworte umfaßt. Wenn immer aus einem Spektralwert ein Codewort gebildet wird, so können hier 10 Spektralwerte codiert sein. Üblicherweise werden jedoch immer 2 oder 4 Spektralwerte durch ein Codewort gemeinsam codiert, weshalb Fig. 6 einen Teil des codierten Bitstroms darstellt, der 20 bzw. 40 Spektralwerte umfaßt. In dem Fall, in dem jedes Huffman-Codewort 2 Spektralwerte umfaßt, stellt das mit der Nr. 1 bezeichnete Codewort die ersten 2 Spektralwerte dar, wobei die Länge des Codeworts Nr. 1 relativ klein ist, was bedeutet, daß die werte der beiden ersten Spektralwerte, d. h. der beiden niedrigsten Frequenzkoeffizienten, relativ häufig auftreten. Das Codewort mit der Nr. 2 hingegen besitzt eine relativ große Länge, was bedeutet, daß die Beträge des 3. und 4. Spektralkoeffizienten im codierten Audiosignal relativ selten sind, weshalb dieselben mit einer relativ großen Bitmenge codiert werden. Aus Fig. 6 ist ferner ersichtlich, daß die Codewörter mit den Nr. 3, 4 und 5, die die Spektralkoeffizienten 5 und 6, bzw. 7 und 8 bzw. 9 und 10 darstellen, ebenfalls relativ häufig auftreten, da die Länge der einzelnen Codewörter relativ gering ist. Ähnliches gilt für die Codewörter mit den Nr. 6 - 10.

Wie es bereits erwähnt wurde, ist es aus Fig. 6 deutlich ersichtlich, daß die Huffman-Codewörter für die codierten Spektralwerte bezüglich der Frequenz linear ansteigend im Bitstrom angeordnet sind, wenn ein Bitstrom betrachtet wird, der durch eine bekannte Codiervorrichtung erzeugt wird.

Ein großer Nachteil von Huffman-Codes im Falle fehlerbehafteter Kanäle ist die Fehlerfortplanzung. Es sei beispielsweise angenommen, daß das Codewort Nr. 2 in Fig. 6 gestört ist. Mit einer gewissen nicht niedrigen Wahrscheinlichkeit ist dann auch die Länge dieses falschen Codeworts Nr. 2 verändert. Dieselbe unterscheidet sich somit von der richtigen Länge. Wenn im Beispiel von Fig. 6 das Codewort Nr. 2 bezüglich seiner Länge durch eine Störung verändert worden ist, ist es für einen Codierer nicht mehr möglich, die Anfänge der Codewörter 3 - 10, d. h. fast des gesamten dargestellten Audiosignals, zu bestimmen. Es können also auch alle anderen Codewörter nach dem gestörten Codewort nicht mehr richtig decodiert werden, da nicht bekannt ist, wo diese Codewörter beginnen, und da ein falscher Startpunkt aufgrund des Fehlers gewählt wurde.

Das europäische Patent Nr. 0612156 schlägt als Lösung für das Problem der Fehlerfortpflanzung vor, einen Teil der Codewörter variabler Länge in einem Raster anzuordnen, und die restlichen Codewörter in die verbleibenden Lücken zu verteilen, so daß ohne vollständige Decodierung oder bei fehlerhafter Übertragung der Anfang eines an einem Rasterpunkte angeordneten Codeworts leichter gefunden werden kann.

Das bekannte Verfahren schafft für die Fehlerfortpflanzung zwar eine teilweise Abhilfe durch Umsortierung der Codewörter. Für manche Codewörter wird ein fester Platz im Bitstrom vereinbart, während für die restlichen Codewörter die verbleibenden Zwischenräume zur Verfügung stehen. Dies kostet keine zusätzlichen Bits, verhindert aber im Fehlerfall die Fehlerfortpflanzung unter den umsortierten Codewörtern.

Entscheidender Parameter für die Effizienz des bekannten Verfahrens ist jedoch, wie das Raster in der praktischen Anwendung bestimmt wird, d. h. wie viele Rasterpunkte verwendet werden müssen, welchen Rasterabstand die Rasterpunkte haben, usw. Das europäische Patent 0612156 liefert jedoch neben dem allgemeinen Hinweis, ein Raster zur Eindämmung der Fehlerfortpflanzung zu verwenden, keine näheren Hinweise darauf, wie das Raster effizient gestaltet werden soll, um einerseits eine fehlerrobuste Codierung und andererseits auch eine effiziente Codierung zu ermöglichen.

Die deutsche Patentanmeldung 19747119.6-31, die nach dem Anmeldetag der vorliegenden Anmeldung veröffentlicht wird, schlägt vor, nicht nur irgendwelche Codeworte an Rasterpunkten anzuordnen, sondern psychoakustisch bedeutsame Codeworte, d. h. Codeworte für spektralwerte, die einen bedeutsamen Beitrag zum Audiosignal liefern, an Rasterpunkten anzuordnen. Ein Datenstrom mit Codeworten variabler Länge, wie er von einem solchen Codierer erzeugt wird, ist in Fig. 5 gezeigt. Der Datenstrom umfaßt ebenfalls wie in Fig. 6 10 Codeworte, wobei die Prioritätscodeworte schraffiert sind. Das erste Prioritätscodewort ist an einem ersten Rasterpunkt 100 beginnend angeordnet, das zweite Prioritätscodewort ist an einem zweiten Rasterpunkt 101 beginnend angeordnet, das dritte Prioritätscodewort ist an einem dritten Rasterpunkt 102 beginnend angeordnet, das vierte Prioritätscodewort ist an einem vierten Rasterpunkt 103 beginnend angeordnet, und das fünfte Prioritätscodewort ist an einem fünften Rasterpunkt 104 beginnend angeordnet. Durch die Rasterpunkte 100 und 101 ist ein erstes Segment 105 definiert. Auf ähnliche Art und Weise ist ein zweites 106, ein drittes 107, ein viertes 108 und ein Abschlußsegment 109 definiert. In Fig. 5 ist gezeigt, daß die ersten beiden Segmente 105 und 106 eine andere Länge als die beiden Segmente 107 und 108 und wieder eine andere Länge als das Schlußsegment 109 haben. Die Nicht-Prioritätscodeworte 6, 7, 8, 9 und 10 werden an die Prioritätscodeworte anschließend in den Datenstrom eingetragen, derart, daß derselbe gewissermaßen aufgefüllt wird. Wie es in Fig. 5 gezeigt ist, werden bei dem nachveröffentlichten Verfahren die Nicht-Prioritätscodeworte fortlaufend in das Raster eingefügt, nachdem die Prioritätscodeworte geschrieben worden sind. Im einzelnen wird das Nicht-Prioritätscodewort Nr. 6 an das Nicht-Prioritätscodewort 1 anschließend eingetragen. Der dann noch in dem Segment 105 verbleibende Platz wird mit den anschließenden Nicht-Prioritätscodewort 7 aufgefüllt, wobei der Rest des Nicht-Prioritätscodeworts 7, d. h. 7b, in den nächsten freien Platz, d. h. in das Segment 107 direkt an das Prioritätscodewort 3 anschließend geschrieben wird. Entsprechend wird mit den Nicht-Prioritätscodeworten 8 bis 10 verfahren.

Das in Fig. 5 dargestellte nachveröffentlichte Verfahren hat den Vorteil, daß die Prioritätscodeworte 1 bis 5 vor einer Fehlerfortpflanzung geschützt sind, da ihre Anfangspunkte mit Rasterpunkten zusammenfallen und damit bekannt sind.

Ist nun beispielsweise das Prioritätscodewort 2 bei der Übertragung beschädigt worden, so wird bei dem in Fig. 6 gezeigten Stand der Technik ein Decodierer sehr wahrscheinlich keines der restlichen Codeworte 3 bis 10 mehr korrekt decodieren können. Bei dem in Fig. 5 gezeigten Verfahren fängt jedoch das nächste Codewort, d. h. das Prioritätscodewort 3, an dem Rasterpunkt 102 an, derart, daß der Decodierer auf jeden Fall den korrekten Anfang des Codeworts 3 finden wird. Somit wird bei dem in Fig. 5 gezeigten Verfahren überhaupt kein Folgefehler auftreten, und es wird nur das Prioritätscodewort Nr. 2 beschädigt sein. Dieses Verfahren liefert somit einen effektiven Schutz für Prioritätscodeworte, die an Rasterpunkten angeordnet sind.

Es besteht jedoch kein effektiver Schutz für Nicht-Prioritätscodeworte. Bezugnehmend auf Fig. 5 wird eine Beschädigung des Nicht-Prioritätscodeworts Nr. 6, derart, daß der Decodierer als falsches Codewort Nr. 6 ein um ein Bit kürzeres Codewort annimmt, dazu führen, daß auch das Codewort 7 nicht mehr korrekt decodiert werden kann, da das letzte Bit des korrekten Codeworts Nr. 6 bereits als Anfang des nächsten Codeworts Nr. 7 interpretiert wird. Somit wird ein Fehler im Codewort Nr. 6 dazu führen, daß sehr wahrscheinlich sämtliche daran anschließende Codeworte aufgrund eines Folgefehlers nicht mehr korrekt decodiert werden können, selbst wenn sie nicht durch einen Übertragungsfehler beeinträchtigt worden sind.

Das U.S.-Patent Nr. 5,579,430 offenbart ein Verfahren zum digitalen Codieren, bei dem die in einen Bitstrom zu schreibenden Codewörter derart in dem Bitstrom angeordnet werden, daß ein Teil der Codewörter zunächst in einem Raster angeordnet wird. Damit tritt in diesem Abschnitt der Codeworte keine Fehlerausbreitung auf. Die restlichen Codewörter werden in den noch verbleibenden Zwischenräumen verteilt.

Die Aufgabe der vorliegenden Erfindung besteht darin, ein Konzept zum Schreiben und Lesen eines Datenstroms aus Codeworten variabler Länge zu finden, daß einen besonderen Schutz gegen Folgefehler aufgrund einer nicht idealen Übertragung des Datenstroms liefert.

Diese Aufgabe wird durch ein Verfahren zum Erzeugen eines Datenstroms gemäß Patentanspruch 1, durch ein Verfahren zum Lesen eines Datenstroms gemäß Patentanspruch 15, durch eine Vorrichtung zum Erzeugen eines Datenstroms gemäß Patentanspruch 20 und eine Vorrichtung zum Lesen eines Datenstroms gemäß Patentanspruch 21 gelöst.

Der vorliegenden Erfindung liegt die Erkenntnis zugrunde, daß ein Datenstrom mit Codeworten variabler Länge derart gestaltet werden muß, daß aufeinanderfolgende Codeworte sobald als möglich in dem Datenstrom voneinander entkoppelt werden, derart, daß ein Decodierer aufgrund eines Übertragungsfehlers nicht eine sehr hohe Anzahl von Folgefehlern erzeugt. Dazu werden zu übertragende Codeworte variabler Länge in eine Mehrzahl von Sätzen unterteilt. Der erste Satz könnte Prioritätscodeworte umfassen, während der zweite Satz Nicht-Prioritätscodeworte umfassen könnte. Um auch die Nicht-Prioritätscodeworte gegen Übertragungsfehler zu schützen, werden sie nicht einfach wie im Stand der Technik in das noch freie Raster geschrieben, sondern in die einzelnen Segmente verteilt. Nach einer festen Zuordnung, die einem Empfänger bekannt ist, werden Nicht-Prioritätscodeworte den Segmenten zugeordnet, derart, daß jedes Nicht-Prioritätscodewort, d. h. jedes Codewort aus dem zweiten Satz, einem anderen Segment des Datenstroms zugeordnet ist. Damit dies funktioniert, darf jeder Satz höchstens so viele Codeworte haben wie Segmente für den Datenstrom vorhanden sind. Somit wird zunächst der erste Satz von Codeworten in das Raster geschrieben, derart, daß jedes Codewort des ersten Satzes an einem Rasterpunkt beginnt. Anschließend wird versucht, jedes Codewort des zweiten Satzes in den Datenstrom zu schreiben, derart, daß jedes Codewort des zweiten Satzes in einem anderen Segment angeordnet ist. Durch diese Zuordnung, d. h. jedes Codewort des zweiten Satzes wird in ein anderes Segment geschrieben, wird ein Decodierer nicht mehr einfach die Codeworte des zweiten Satzes nacheinander decodieren, sondern für jedes Codewort des zweiten Satzes im Raster zu dem entsprechenden Segment gehen, um das entsprechende Codewort des zweiten Satzes dann aus diesem Segment zu extrahieren.

Ist ein Segment bereits nach dem Schreiben des Codeworts des ersten Satzes in dieses Segment so voll, daß das diesem Segment zugeordnete Codewort des zweiten Satzes nur teilweise oder gar keinen Platz mehr hat, so wird der Teil des Codeworts des zweiten Satzes, der noch Platz hat, in das zugeordnete Segment geschrieben und der Rest gespeichert. Hat das Codewort überhaupt keinen Platz, so wird das gesamte Codewort gespeichert, bis die Zuordnung jedes Codeworts des zweiten Satzes versucht worden ist. Erst dann wird ein zweiter Versuch unternommen, um die gespeicherten Teile bzw. die gespeicherten kompletten Codeworte des zweiten Satzes nach einer vorbestimmten Vorschrift an noch freie Segmentabschnitte zu schreiben.

Ist das Raster derart gestaltet, daß Codeworte des ersten Satzes existieren, die länger als die Segmentlänge sind, so kann das selbe Verfahren bereits für das Schreiben des ersten Satzes von Codeworten angewendet werden.

Ein Decodierer geht dann, wenn er die an Rasterpunkten beginnenden Codeworte des ersten Satzes aus dem Datenstrom extrahiert hat, zum Extrahieren der Codeworte des zweiten Satzes über. Findet ein Decodierer nur einen Teil eines Codewortes des zweiten Satzes von Codeworten, so wird dieser Teil gespeichert und es wird damit fortgefahren, in einem anderen Segment nach dem nächsten Codewort des zweiten Satzes zu suchen. Erst wenn alle Segmente in einem solchen ersten Versuch durchsucht worden sind, wird noch in einem zweiten bzw. einem weiteren Versuch der fehlende Teil eines Codeworts des zweiten Satzes ermittelt bzw. überhaupt ein Codewort des zweiten Satzes ermittelt, dessen zugeordnetes Segment bereits durch das Codewort des ersten Satzes vollständig belegt war.

Damit wird bezugnehmend auf Fig. 5 ein Fehler im Codewort Nr. 6 nicht mehr zu einem Fehler im Codewort Nr. 7 führen, da das Codewort Nr. 7 in einem anderen Segment als dem Segment 105 beginnen würde und sich an das Codewort Nr. 6 ein vollständig anderes nicht zu dem selben benachbartes Codewort anschließen würde.

Zur weiteren Veranschaulichung sei ein einfaches Beispiel betrachtet. Es wird von zwei Codeworten im ersten Satz und von zwei Codeworten im zweiten Satz, also von insgesamt 4 Codeworten variabler Länge ausgegangen. Ferner wird zum Vergleich mit dem Stand der Technik angenommen, daß die Codeworte 1 und 3 zusammen so lang sind, daß sie in das erste Segment passen, und daß die Codeworte 2 und 4 zusammen so lang sind, daß sie komplett in das zweite Segment passen. In diesem Fall würde eine Vorrichtung gemäß dem Stand der Technik denselben Datenstrom schreiben wie eine Vorrichtung gemäß der vorliegenden Erfindung. Die Vorrichtung gemäß dem Stand der Technik würde zunächst die Prioritätscodeworte 1 und 2 an die beiden Rasterpunkte schreiben und dann das Codewort Nr. 3 an das Codewort Nr. 1 anschließend schreiben und das Codewort Nr. 4 an den nächsten freien Platz im Raster, also an das Codewort Nr. 2 anschließend schreiben. Lediglich zufällig steht somit das Codewort Nr. 4 nicht mehr (zumindest teilweise) im ersten Segment sondern vollständig im zweiten Segment.

Eine erfindungsgemäße Vorrichtung wird zunächst die Codeworte des ersten Satzes an die entsprechenden Rasterpunkte schreiben und dann das erste Codewort des zweiten Satzes in das erste Segment schreiben und das Codewort des zweiten Satzes in das zweite Segment schreiben, und zwar unabhängig davon, ob im ersten Segment noch Platz ist oder nicht. Die erfindungsgemäße Vorrichtung wird somit auf jeden Fall versuchen, jedes Codewort des zweiten Satzes in ein anderes Segment zu schreiben.

Obwohl die beiden Datenströme zufällig identisch aussehen, ergibt sich doch ein wesentlicher Unterschied für den Empfänger, der die Codeworte variabler Länge wieder aus dem Datenstrom extrahiert, um sie wieder in ihre für einen Decodierer benötigte Reihenfolge zu bringen. Im Stand der Technik wird eine Vorrichtung zum Extrahieren zunächst das Codewort Nr. 1 am ersten Rasterpunkt und das Codewort Nr. 2 am zweiten Rasterpunkt lesen, um die Codeworte des ersten Satzes zu erhalten. Dann wird eine Vorrichtung gemäß dem Stand der Technik an den Beginn des verbleibenden Datenstroms gehen und dort das Codewort Nr. 3 lesen und darin anschließend das Codewort Nr. 4 lesen.

Eine Vorrichtung gemäß der vorliegenden Erfindung wird nach dem Lesen der Codeworte 1 und 2 des ersten Satzes ebenfalls an den Beginn des verbleibenden Datenstroms gehen und dort das Codewort Nr. 3 lesen. Dann wird die erfindungsgemäße Vorrichtung jedoch in das nächste Segment springen, um dort den Beginn des vierten Codeworts, d. h. des zweiten Codeworts des zweiten Satzes, zu finden.

Im nachfolgenden wird nun angenommen, daß das Codewort Nr. 3, d. h. das erste Codewort des zweiten Satzes, das in dem fiktiven Datenstrom hinter das erste Codewort des ersten Satzes geschrieben wurde, derart gestört worden ist, daß ein Decodierer dasselbe als ein kürzeres Codewort interpretieren wird, als es tatsächlich ist. In diesem Fall wird die bekannte Vorrichtung zum Lesen des Datenstroms Codewort Nr. 3 lesen und aufgrund des Übertragungsfehlers zu früh aufhören und das bzw. die restlichen Bits, die eigentlich zu dem Codewort Nr. 3 gehörten, bereits als Beginn des Codeworts Nr. 4 werten. Die erfindungsgemäße Vorrichtung wird jedoch nach Abschluß des Codeworts Nr. 3 ins nächste Segment springen und somit korrekt den Anfang des Codeworts Nr. 4 ermitteln.

Anhand dieses einfachen Beispiels ist deutlich der wesentliche Vorteil der vorliegenden Erfindung zu sehen, derart, daß sie aufgrund der Aufteilung der Codeworte des zweiten Satzes in die einzelnen Segmente Folgefehler auch in Codeworten des zweiten Satzes, die beispielsweise Nicht-Prioritätscodworte sein könnten, verhindert. Im Stand der Technik treten dagegen Folgefehler auf, wie es bezugnehmend auf Fig. 5 beschrieben wurde, obwohl die Datenströme aus Codeworten variabler Länge, die durch den Stand der Technik und durch die vorliegende Erfindung erzeugt werden, zufällig identisch sein könnten.

Bevorzugte Ausführungsbeispiele der vorliegenden Erfindung werden nachfolgend bezugnehmend auf die beiliegenden Zeichnungen detailliert erläutert. Es zeigen:
- Fig. 1: eine erfindungsgemäße Vorrichtung zum Erzeugen eines Datenstroms aus Codeworten variabler Länge;
- Fig. 2: eine erfindungsgemäße Vorrichtung zum Lesen eines Datenstroms mit Codeworten variabler Länge;
- Fig. 3: ein Verfahrensablaufdiagramm des erfindungsgemäßen Verfahrens anhand von drei Sätzen von Codeworten variabler Länge;
- Fig. 4: ein Verfahrensablaufdiagramm zur Veranschaulichung des erfindungsgemäßen Verfahrens zum Lesen eines Datenstroms, der gemäß Fig. 3 erzeugt worden ist;
- Fig. 5: ein Datenstrom, der durch eine bekannte Vorrichtung erzeugt wird, bei dem die Prioritätscodeworte einer Fehlerfortpflanzung ausgesetzt sind; und
- Fig. 6: ein Datenstrom, bei dem eine Sortierung in Prioritätscodeworte und Nicht-Prioritätscodeworte durchgeführt ist.

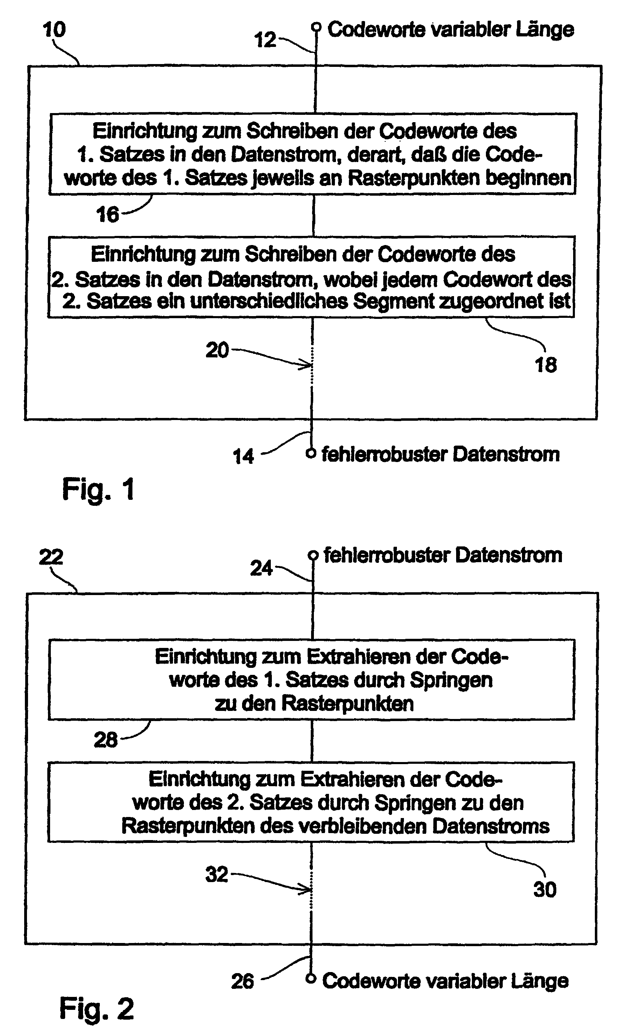

Bevor auf Fig. 1 näher eingegangen wird, sei angemerkt, daß eine Codierung mit Codeworten variabler Länge in der Technik auch als Entropie-Codierung bezeichnet wird. Ein Vertreter der Entropie-Codierung ist die sogenannte Huffman-Codierung. Prinzipiell werden bei der Huffman-Codierung die zu codierenden Informationssymbole statistisch untersucht, um für die Informationssymbole, die häufiger auftreten, kürzere Codeworte zu bestimmen als für Informationssymbole, die weniger häufig auftreten. Bei einem vollständigen Huffman-Code sind sämtliche Codeworte abgeschlossene Enden oder Zweige eines Codebaums. Ein Huffman-Decodierer liest einen Datenstrom mit Huffman-Codeworten beispielsweise seriell ein und springt anschaulich gesprochen mit jedem Bit, das er zusätzlich einliest, zu einer Verzweigung des festgelegten Codebaums, bis er nach einer bestimmten Anzahl von Sprüngen, die der Anzahl von Bits des Codeworts, d. h. der Länge des Codeworts, entspricht, an einem Zweigende ankommt, das keine weitere Verzweigung aufweist, und somit ein Codewort ist. Dann weiß der Decodierer, daß mit dem nächsten Bit ein neues Codewort beginnt. Dieses Verfahren wird so oft wiederholt, bis der Datenstrom vollständig eingelesen ist. Mit jedem Mal, zu dem der Huffman-Codierer wieder an den Anfangspunkt, d. h. die Wurzel des Baumes zurückspringt, liegt an seinem Ausgangspunkt ein Codewort vor. Da die Länge der Codeworte implizit durch die Codeworte selbst bzw. durch den im Codierer und im Decodierer bekannten Codebaum gegeben ist, ist zu sehen, daß eine Störung im Datenstrom, die zu einer Umkehrung eines Bits führt, den Decodierer in dem Codebaum gewissermaßen irreführt, derart, daß er zu einem anderen Codewort, d. h. einem falschen Codewort, gelangt, das sehr wahrscheinlich eine andere Länge hat als das richtige Codewort. In diesem Fall wird der Decodierer, wenn er an dem falschen Codewort angelangt ist, wieder zurückspringen und aufgrund der dann folgenden Bits wieder von Verzweigungspunkt zu Verzweigungspunkt in dem Codebaum laufen. Der Decodierer hat jedoch keine Möglichkeit, einen Folgefehler zu vermeiden, es sei denn, daß er zufällig wieder auf die "richtige Spur" kommt.

Daher müssen für eine fehlerrobuste Übertragung Fehlersicherungen unternommen werden, wie sie die vorliegende Erfindung vorsieht. Die Vorrichtung zum Erzeugen eines Datenstroms aus Codeworten variabler Länge gemäß der vorliegenden Erfindung könnte daher gewissermaßen als Sende- oder Ausgangsstufe eines Huffman-Codierers fungieren, während die Vorrichtung zum Lesen eines Datenstroms aus Codeworten variabler Länge als Empfangs- bzw. Eingangsstufe eines Huffman-Decodierers wirken könnte. Daraus ist jedoch zu sehen, daß die vorliegende Erfindung nicht nur auf Huffman-Codierer anwendbar ist, sondern auf jeglichen Code mit Codeworten variabler Länge, der für Folgefehler anfällig ist.

Fig. 1 zeigt eine erfindungsgemäße Vorrichtung 10 zum Erzeugen eines Datenstroms aus Codeworten variabler Länge, die einen Eingang 12 und einen Ausgang 14 aufweist. An dem Eingang 12 liegen die Codeworte variabler Länge an, während an dem Ausgang 14 der fehlerrobuste Datenstrom ausgegeben wird. Die Codeworte variabler Länge am Eingang 12 der Vorrichtung 10 sind bevorzugterweise bereits vorsortiert, derart, daß Prioritätscodeworte in einem ersten Satz sind, weniger wichtige Codeworte in einem zweiten Satz sind, wieder weniger wichtige Codeworte in einem dritten Satz sind etc.

Die Codeworte variabler Länge werden in eine Einrichtung 16 zum Schreiben der Codeworte des ersten Satzes in den Datenstrom, derart, daß die Codeworte des ersten Satzes jeweils an Rasterpunkten beginnen, eingegeben.

Die Codeworte variabler Länge werden ferner in eine Einrichtung 18 zum Schreiben der Codeworte des zweiten Satzes in den Datenstrom eingegeben, wobei jedem Codewort des zweiten Satzes ein unterschiedliches Segment zugeordnet ist. Der Datenstrom zwischen den beiden Einrichtungen 16 und 18 ist somit ein Datenstrom, bei dem lediglich sämtliche Codeworte des ersten Satzes an Rasterpunkten eingetragen sind. Bestehen die Codeworte variabler Länge lediglich aus zwei Sätzen von Codeworten, so liegt am Ausgang der Einrichtung 18 bereits der fehlerrobuste Datenstrom vor. Existieren mehr als zwei Sätze von Codeworten variabler Länge, so existieren weitere Einrichtungen zum Schreiben der Codeworte des entsprechenden Satzes in den Datenstrom, was durch das Bezugszeichen 20 symbolisch dargestellt ist.

Fig. 2 zeigt eine erfindungsgemäße Vorrichtung 22 zum Lesen des an dem Ausgang 14 (Fig. 1) ausgegebenen fehlerrobusten Datenstroms, die einen Eingang 24 und einen Ausgang 26 aufweist. An dem Eingang 24 wird der fehlerrobuste Datenstrom eingegeben, um an dem Ausgang 26 Codeworte variabler Länge auszugeben, deren Reihenfolge der Reihenfolge entspricht die an dem Eingang 12 (Fig. 1) vorgelegen hat. Die Vorrichtung 22 zum Lesen des Datenstroms umfaßt eine Einrichtung 28 zum Extrahieren der Codeworte des ersten Satzes durch Springen zu den Rasterpunkten, eine nachgeschaltete Einrichtung 30 zum Extrahieren der Codeworte des zweiten Satzes durch Springen zu den Rasterpunkten des verbleibenden Datenstroms sowie gegebenenfalls weitere Einrichtungen 32 zum Extrahieren von Codeworten entsprechend der weiteren Sätze, falls solche vorhanden sind.

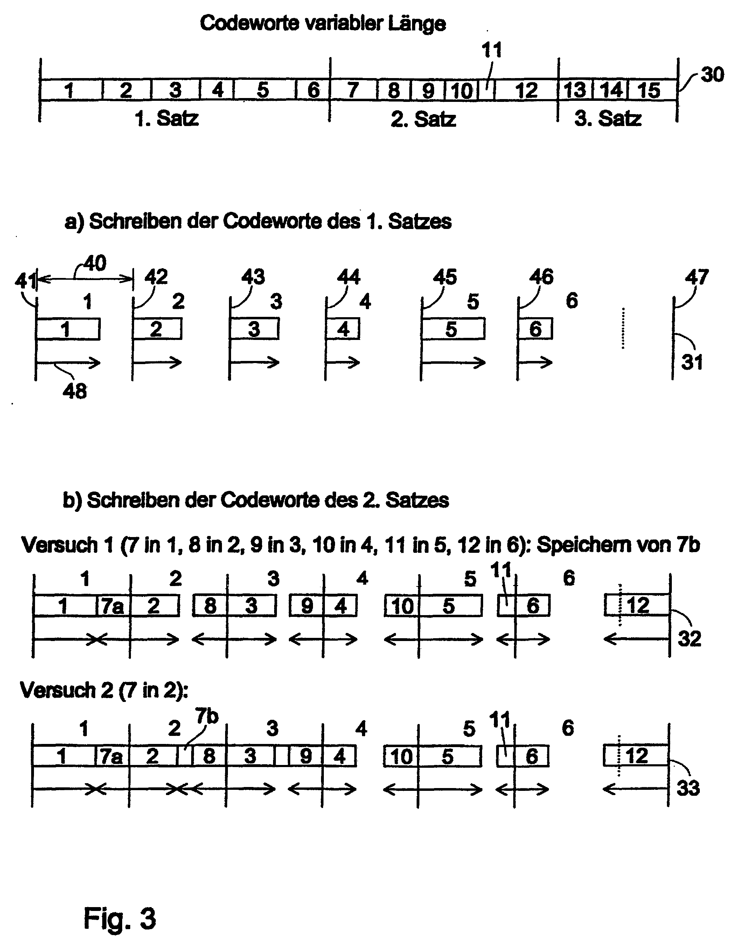

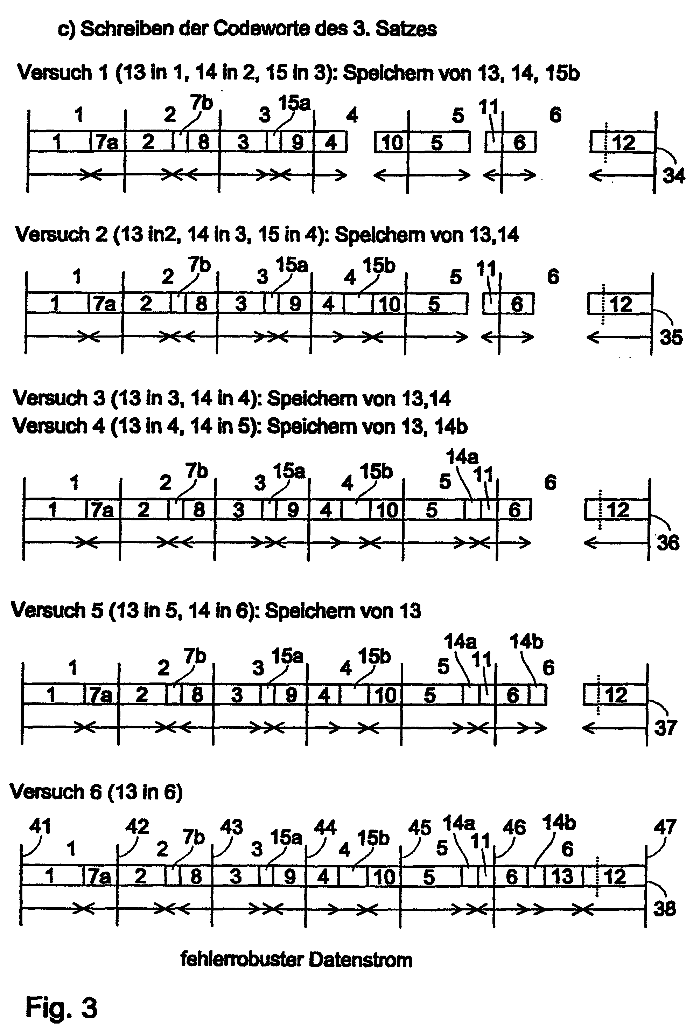

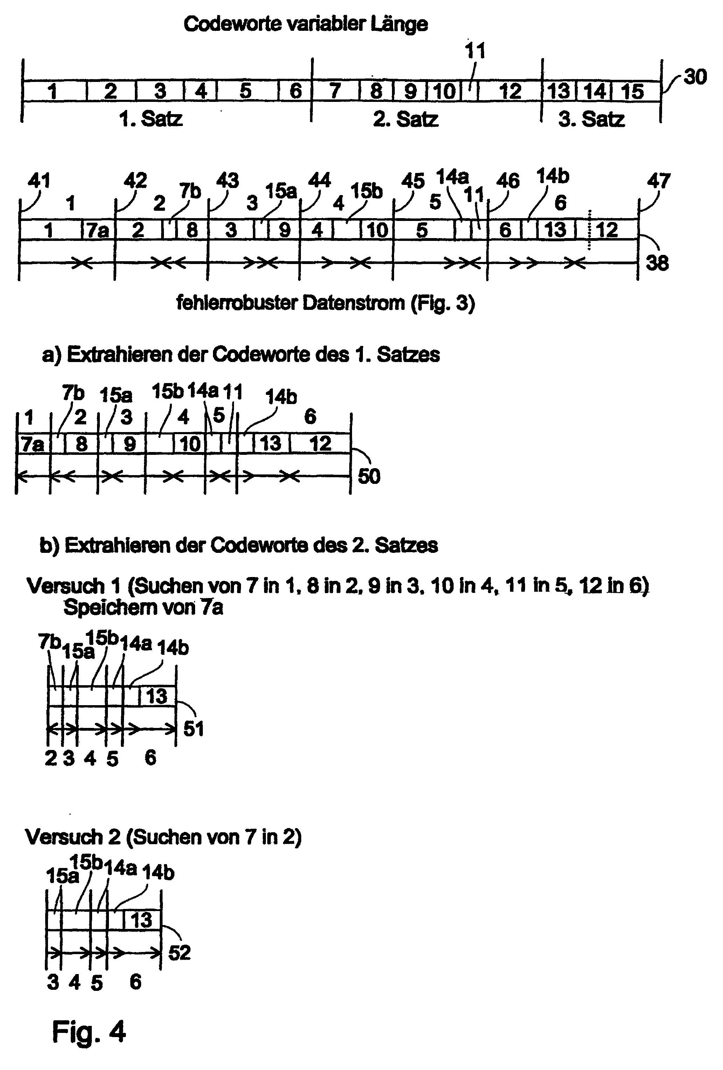

Bevor anhand von Fig. 3 das durch die Vorrichtung 10 (Fig. 1) ausgeführte Verfahren anhand eines Beispiels detailliert ausgeführt wird, wird zunächst eine zusammenfassung des Verfahrens gegeben. So werden die verfügbaren Codeworte in eine Mehrzahl von Sätzen aufgeteilt. Jeder Satz mit Ausnahme des letzten umfaßt soviele Codeworte wie Segmente verfügbar sind. Im günstigsten Fall enthält ein Satz so viele Codeworte wie Segmente vorhanden sind, ein Satz kann aber auch mehr oder weniger enthalten, wie es für den letzten Satz nahezu zwangsläufig der Fall sein wird, da von einer vorbestimmten Anzahl von Codeworten variabler Länge ausgegangen werden muß. Sind M Segmente vorhanden und hat ein Satz N Codeworte, so entspricht die Anzahl der Codeworte, die an Rasterpunkte geschrieben werden, dem Minimum aus M und N, während die Anzahl der Versuche, die N Codeworte in dem Raster erfindungsgemäß unterzubringen, dem Maximum aus M und N entspricht.

Der erste Satz enthält vorzugsweise die wichtigsten Codeworte, d. h. die Prioritätscodeworte, die Informationssymbole darstellen, die im Vergleich zu den anderen Informationssymbolen bedeutsamer sind. Die folgenden Sätze enthalten weniger wichtige Codeworte in der Reihenfolge, wie sie durch einen Vorsortieralgorithmus geliefert wird, der vorzugsweise auch die Einteilung in Prioritätscodeworte und Nicht-Prioritätscodeworte durchführt. Diese Sätze werden durch die Einrichtung 10 aufeinanderfolgend geschrieben. Das Schreiben eines Satzes dürfte mehrere Versuche benötigen. Im ersten Versuch wird das erste Codewort des aktuellen Satzes in das erste Segment geschrieben und so weiter, bis das letzte Codewort des gegenwärtigen Satzes in das letzte Segment geschrieben wird. Selbstverständlich könnte auch mit dem zweiten, mit dem dritten oder mit irgendeinem anderen Segment begonnen werden und dann nach einer bestimmten festgelegten Vorschrift jedes Segment beschrieben werden.

Wenn ein Codewort nicht in ein Segment paßt, wird der restliche Teil dieses Codeworts gespeichert. Im zweiten Versuch wird der restliche Teil des ersten Codeworts, falls vorhanden, in vorzugsweise das zweite Segment geschrieben usw., bis der restliche Teil des letzten Codeworts vorzugsweise in das erste Segment geschrieben wird. Ein solcher Algorithmus kann auch als Modulo-Verschiebung bezeichnet werden. Selbstverständlich ist die vorbestimmte Vorschrift, ob ein Rest eines Codeworts im nächsten Durchgang, d. h. im nächsten Versuch, in das darauffolgende Segment, in das übernächste Segment usw. geschrieben wird, beliebig.

Wenn ein Satz vollständig geschrieben ist, beginnt das Schreiben des nächsten Satzes. Um gemäß einem bevorzugten Ausführungsbeispiel der vorliegenden Erfindung Fortpflanzungsfehler noch stärker zu unterbinden, wird die Schreibrichtung innerhalb des Segments von Satz zu Satz verändert. Codeworte des ersten Satzes werden z.B. von links nach rechts geschrieben, während Codeworte des zweiten Satzes von rechts nach links geschrieben werden usw. Somit wird auch gemäß diesem bevorzugten Ausführungsbeispiel mit der vorliegenden Erfindung die zweite Seite eines Rasterpunktes für eine gewissermaßen absolute Fehlersicherung ausgenutzt.

Die Verwendung des im vorhergehenden kurz zusammengefaßten Schemas kann die Anzahl von Fehlerausbreitungsmöglichkeiten für ein bestimmtes Codewort sehr stark reduzieren. Da die Sätze aufeinanderfolgend geschrieben werden und da jedes Codewort eines Satzes einem bestimmten Segment zugeordnet ist und auch in das Segment geschrieben wird, falls noch Platz in diesem Segment ist, ist keine Fehlerausbreitungsmöglichkeit von einem Codewort innerhalb eines Satzes zum nächsten Codewort innerhalb des Satzes möglich, da ein Decodierer beim Decodieren immer von Segment zu Segment springt und nicht wie beim Stand der Technik den Beginn eines Codeworts dort annimmt, wo das vorausgehende endete. Für den Fall, daß ein Codewort nur teilweise in dieses Segment geschrieben wird, da der vorhandene Platz nicht mehr reicht, um das Codewort vollständig einzutragen, wird die Möglichkeit der Fehlerausbreitung zumindest reduziert.

Gemäß einem bevorzugten Ausführungsbeispiel der vorliegenden Erfindung wird die Segmentbreite derart gewählt, daß die Prioritätscodeworte vollständig in die Segmente passen. Daher benötigt das Schreiben des ersten Satzes nur einen Versuch. Dies ist jedoch beliebig. Da generell eine hohe Anzahl von Rasterpunkten für einen Datenstrom, d. h. eine möglichst kleine Segmentlänge angestrebt wird, dürfte auch der Fall aufkommen, daß auch Codeworte des ersten Satzes länger als die Segmentlänge sind. Dieser Fall würde jedoch ebenfalls wie das Schreiben des zweiten Satzes, d. h. ebenfalls nach einer vorbestimmten Vorschrift, die sowohl dem Codierer als auch dem Decodierer bekannt sein müssen, behandelt werden.

In Fig. 3 ist anhand eines Beispiels das erfindungsgemäße Verfahren zum Schreiben von Codeworten variabler Länge dargestellt. Im Beispiel existieren 15 Codeworte variabler Länge 30, die vorzugsweise in einen ersten Satz mit 6 Codeworten 1 bis 6, in einen zweiten Satz mit ebenfalls 6 Codeworten 7 bis 12 und in einen dritten Satz mit den restlichen 3 Codeworten 13 bis 15 aufgeteilt sind. Wie es in Fig. 3 gezeigt ist, haben die Codeworte 30 variable Längen.

Gemäß einem bevorzugten Ausführungsbeispiel der vorliegenden Erfindung ist die Segmentlänge, d. h. die Länge eines Segments, größer als die Länge des längsten Codeworts des ersten Satzes. Die Codeworte des ersten Satzes werden an Rasterpunkten 41 bis 46 angeordnet, wobei für das letzte Segment Nr. 6 ein Rasterpunkt gestrichelt angedeutet ist, der jedoch nicht verwendet wird, da das Ende 47 des Datenstroms gewissermaßen ebenfalls als Rasterpunkt angesehen werden kann und der gestrichelt angedeutete Rasterpunkt somit überflüssig ist. Das erste Segment Nr. 6 ist daher länger als die anderen Segmente, was für die vorliegende Erfindung jedoch völlig unerheblich ist. Die Segmente können allgemein gesagt beliebige Längen haben, die sich innerhalb des Datenstroms ändern, wobei jedoch die aktuelle Länge eines Segments selbstverständlich dem Decodierer bekannt sein muß, damit die erfindungsgemäßen Vorteile genutzt werden können.

Zunächst werden in einem Schritt a) die Codeworte des ersten Satzes in den Datenstrom geschrieben, woraus sich ein mit 31 bezeichneter bruchstückhafter Datenstrom ergibt, bei dem die Codeworte des ersten Satzes von links nach rechts in ein jeweiliges Segment geschrieben werden, wie es durch Pfeile 48 angedeutet ist, die in der gesamten Fig. 3 die Schreibrichtung symbolisieren sollen. Da die Segmentlänge länger als die größte Länge eines Codeworts des ersten Satzes gewählt ist, wird für den Schritt a) lediglich ein einziger Versuch benötigt. Sind die Segmente kürzer, werden entsprechend mehr Versuche benötigt.

In einem Schritt b) werden nun die Codeworte des zweiten Satzes in den Datenstrom 31 geschrieben. Um eine hohe Fehlerrobustheit zu erreichen, werden die Codeworte des zweiten Satzes bevorzugterweise nicht von links nach rechts wie die Codeworte des ersten Satzes geschrieben, sondern jeweils ausgehend von dem zweiten Rasterpunkt z.B. dem Rasterpunkt 42 für das erste Segment, von rechts nach links geschrieben, wie es durch den entsprechenden Schreibrichtungspfeil angedeutet ist. Das Schreiben der Codeworte des zweiten Satzes findet nach einer vorbestimmten Zuordnungsvorschrift statt, die bei dem gewählten Beispiel derart lautet, daß das erste Codewort des zweiten Satzes in dem gleichen Segment geschrieben werden soll wie das erste Codewort des ersten Satzes, jedoch immer unter der Voraussetzung, daß in diesem Segment noch Platz ist. Der aus dem ersten Versuch entstandene Datenstrom 32 zeigt, daß im ersten Segment lediglich soviel Platz war, den Anfangsabschnitt des Codeworts Nr. 7 zu schreiben.

Im Gegensatz zum Stand der Technik, bei dem der zweite Teil des Codeworts Nr. 7 in das zweite Segment geschrieben worden wäre, wird die zweite Hälfte des Codeworts Nr. 7, d. h. 7b, gespeichert, um dasselbe nach einer vorbestimmten Vorschrift, d. h. nach einer Vorschrift die auch dem Decodierer bekannt sein muß, in einem zweiten Versuch in den Datenstrom zu schreiben. Fig. 3 macht deutlich, daß in dem zweiten Segment zwischen dem Codewort Nr. 2 und 8 noch soviel Platz vorhanden war, daß der Endabschnitt des Codeworts Nr. 7 eingetragen werden konnte. Wäre nicht genug Platz gewesen, so wäre der dritte Abschnitt des Codeworts in das Segment Nr. 3 eingetragen worden. Die vorbestimmte Vorschrift zum Eintragen des Codeworts Nr. 7 in den Datenstrom besteht bei Fig. 3 also darin, immer um ein Segment weiter zu gehen. Selbstverständlich könnte auch immer um zwei Segmente weitergegangen werden, oder um drei oder mehr, derart, daß dann der zweite Abschnitt 7b statt in das zweite Segment in das dritte, im nächsten Versuch in das fünfte etc. geschrieben werden könnte. Die Reihenfolge der Segmente, die verwendet wird, um den zweiten Teil des Abschnitt 7 irgendwo unterzubringen, ist beliebig. Sie muß jedoch dem Decodierer transparent sein, damit der umsortierte Datenstrom wieder gelesen werden kann.

In den entstandenen ebenfalls noch bruchstückhaften Datenstrom 33 sollen nun die Codeworte des dritten Satzes 13 bis 15 eingetragen werden. In Analogie zu dem Schritt b) geschieht dies vorzugsweise anhand der selben Zuordnungsvorschrift, derart, daß das erste Codewort des dritten Satzes dem ersten Segment zugeordnet ist, das zweite Codewort des dritten Satzes dem zweiten Segment zugeordnet ist, das dritte Codewort des dritten Satzes dem dritten Segment zugeordnet ist usw. Diese Zuordnungsvorschrift ist für den dritten Satz völlig beliebig und kann sich auch von der zuordnungsvorschrift für den zweiten Satz unterscheiden, wobei erfindungsgemäß jedes Codewort eines Satzes einem anderen Segment zugeordnet ist.

Der erste Versuch im Schritt c) war lediglich darin erfolgreich, den ersten Abschnitt des Codeworts Nr. 15 einzutragen, wodurch sich ein bruchstückhafter Datenstrom 34 ergeben hat. Die Codeworte 13, 14 und der zweite Abschnitt des Codeworts 15, d. h. 15b, werden gespeichert, um im zweiten, dritten, vierten, fünften und sechsten Versuch untergebracht zu werden, wobei im zweiten Versuch der zweite Abschnitt 15b im vierten Segment untergebracht werden konnte (Datenstrom 35), im dritten Versuch nichts untergebracht werden konnte, im vierten Versuch der Anfangsabschnitt des Codeworts 14 untergebracht werden konnte (Datenstrom 36), im fünften Versuch der Endabschnitt des Codeworts 14, d. h. 14b, untergebracht werden konnte (Datenstrom 37), und schließlich im sechsten und letzten Versuch das erste Codewort des dritten Satzes im sechsten Segment eingetragen werden konnte, wodurch sich der fehlerrobuste Datenstrom 38 für das hier skizzierte Beispiel ergibt. Das anhand von Fig. 3 beschriebene verfahren stellt sicher, daß die Länge des fehlerrobusten Datenstroms genau der Summe der Längen der Codeworte variabler Länge entspricht, was im Sinne einer Entropiecodierung zur Datenreduzierung selbstverständlich ist. Die vorliegende Erfindung ist jedoch nicht darauf begrenzt, daß der fehlerrobuste Datenstrom die minimale Länge hat, da die Fehlerrobustheit nicht durch unter Umständen vorhandene Leerbits beeinträchtigt wird.

Wenn der in Fig. 3 gegebene robuste Datenstrom betrachtet wird, so ist zu sehen, daß der Anfang des Codeworts Nr. 8, d. h. der Rasterpunkt 43, völlig unabhängig von dem Ende des Codeworts Nr. 7 ist. Auch der Anfang des Codeworts Nr. 9, d. h. der Rasterpunkt 44, ist völlig unabhängig von dem Ende des Codeworts Nr. 8. Ferner sei darauf hingewiesen, daß aufgrund der entgegengesetzten Schreibreihenfolge beispielsweise ein Datenfehler im Codewort Nr. 1 im ersten Segment, der dazu führt, daß das falsche Codewort aufgrund des Datenfehlers um ein Bit kürzer als das korrekte Codewort Nr. 1 ist, nicht zu einer Zerstörung des Anfangsabschnitts des Codeworts Nr. 7a führt, da dasselbe statt von links nach rechts von rechts nach links geschrieben wurde. Wäre dasselbe von links nach rechts geschrieben worden, so würde ein Decodierer das noch übrige Bit von dem ursprünglich korrekten Codewort Nr. 1 als Anfangsbit des Codeworts Nr. 7 nehmen, wodurch sich ein Folgefehler von 1 auf 7 ergeben würde. Dieser Folgefehler würde sich jedoch nicht auf 8 fortpflanzen, da Codewort Nr. 8 wieder völlig unabhängig von Codewort Nr. 7 ist, da die Schreibreihenfolge von rechts nach links gewählt wurde. Ist die Schreibreihenfolge des Codeworts Nr. 8 gleich der Schreibreihenfolge der Codeworte des ersten Satzes, so würde sich der Fehler ebenfalls nicht von 7 auf 8 fortpflanzen, da das Codewort Nr. 8 vor dem zweiten Teil 7b aufgrund der Zuordnungsvorschrift an das Codewort Nr. 2 angrenzend geschrieben werden würde und somit nicht durch einen falschen Abschnitt 7b beeinflußt wird.

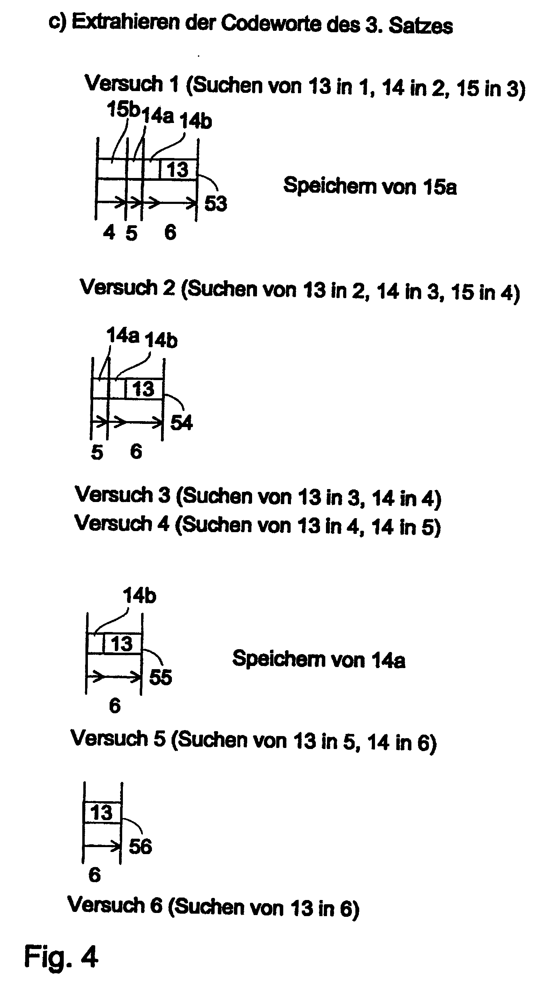

Fig. 4 zeigt anhand eines entsprechenden Beispiels die Funktionsweise der Vorrichtung zum Lesen des fehlerrobusten Datenstroms 38 auf. Zunächst werden in einem Schritt a) die Codeworte des ersten Satzes aus dem fehlerrobusten Datenstroms extrahiert. Dazu liest die erfindungsgemäße Vorrichtung, die mit einem Huffman-Decodierer gekoppelt sein dürfte, ausgehend von dem ersten Rasterpunkt 41 das Codewort des ersten Satzes, ausgehend von dem zweiten Rasterpunkt 42 das Codeworts Nr. 2 des ersten Satzes, usw. bis alle Codeworte 1 bis 6 des ersten Satzes eingelesen sind. Selbstverständlich wählt auch die Vorrichtung zum Lesen des Datenstroms die selbe Richtung, wie sie von der Vorrichtung zum Erzeugen angewendet worden ist.

Anschließend werden in einem Schritt b) aus dem noch verbleibenden Datenstrom 50 die Codeworte des zweiten Satzes extrahiert. Hierbei springt der Decodierer an den zweiten Rasterpunkt 42 des ersten Segments und erhält den Anfangsabschnitt des Codeworts 7 des zweiten Satzes und liest dann nicht den zweiten Abschnitt 7b ein, sondern 7a wird zunächst gespeichert, um dann das zweite Codewort des zweiten Satzes ausgehend von dem zweiten Rasterpunkt des zweiten Segments usw. einzulesen. Es ergibt sich somit ein Restdatenstrom 51, in dem das erste Segment schon vollständig geleert ist. Da der Decodierer nun nicht das Codewort 7 durchgehend liest sondern immer segmentweise aufgrund der Vorrichtung zum Erzeugen des Datenstroms verwendeten Zuordnungsvorschrift liest, wird die bereits beschriebene Fehlerrobustheit sichergestellt, die eine Ausbreitung von Folgefehlern stark reduziert.

In einem zweiten Versuch zum Extrahieren der Codeworte des zweiten Satzes wird nun im zweiten Segment entsprechend der vorhandenen Schreibrichtung der zweite Teil des Codeworts 7b gelesen, woraufhin in dem resultierenden Datenstrom 52 nur noch Codeworte des dritten Satzes verbleiben. (Das zweite Segment ist nun ebenfalls leer.) Diese werden in einem Schritt c) extrahiert, wobei zunächst in einem ersten Versuch der Anfangsabschnitt des Codeworts 15 eruiert worden ist, der jedoch gespeichert wird, da das Codewort 15 nicht vollständig in dem dritten Segment aufgefunden worden ist. Das dritte Segment ist nun ebenfalls leer, die Rasterpunkte existieren jedoch nach wie vor, damit der Decodierer sich an denselben orientieren kann. In einem zweiten Versuch kann das Codewort 15 vollständig gefunden werden. Die Suche nach dem Codewort 14 im Segment 3 und nach dem Codewort 15 im Segment 4 blieb jedoch erfolglos, was durch den Datenstrom 54 sichtbar ist. Im vierten Versuch führte jedoch die Suche von Codewort 14 im fünften Segment zu einem positiven Ergebnis. Das Codewort 14 war jedoch nicht vollständig, weshalb der Anfangsabschnitt 14a gespeichert wurde, um dann in einem fünften Versuch den noch verbleibenden Datenstrom 55 zu untersuchen und schließlich in einem letzten sechsten Versuch den Datenstrom 56, der nur noch aus dem sechsten Segment und aus dem Codewort 13 besteht, vollständig einzulesen.

Obwohl im vorhergehenden Beispiel lediglich eine Stückelung in Anfangsabschnitt und Endabschnitt von Codeworten beispielhaft dargestellt worden ist, ist prinzipiell eine beliebige Stückelung möglich. Solange der Decodierer die Zuordnung von Codeworten des zweiten Satzes bzw. des dritten Satzes und weiterer Sätze zu jeweils unterschiedlichen Segmenten beachtet, wird eine fehlerrobuste Decodierung sichergestellt sein. Es ist ferner offensichtlich, daß die Einsortierung der Endabschnitte von Codeworten in den Datenstrom beliebig ist, solange der Decodierer bzw. die dem Decodierer vorgeschaltete Einleseschaltung genau weiß, welche vorbestimmte Vorschrift im Codierer ausgeführt worden ist.

## Patentansprüche

1. Verfahren zum Erzeugen eines Datenstroms aus Codeworten variabler Länge, die in einer Mehrzahl von Sätzen von Codeworten unterteilt sind, wobei für den Datenstrom ein Raster mit Rasterpunkten vorliegt, wobei zwei benachbarte Rasterpunkte (41, 42) ein Segment (40) definieren, wobei das Raster eine Mehrzahl von Segmenten aufweist, mit folgenden Schritten:
a1) Schreiben (16) der Codeworte (1-6) des ersten Satzes, derart, daß Anfänge der Codeworte an Rasterpunkten unterschiedlicher Segmente liegen; und
a2) falls ein Codewort länger als ein Segment ist, Schreiben des Rests des Codeworts in einen Bereich des Rasters, der nach dem Schritt a1) nicht beschrieben ist, entsprechend einer ersten vorbestimmten Vorschrift, bis alle Codeworte des ersten Satzes in das Raster geschrieben sind;
**gekennzeichnet durch** folgende Schritte:
b1) Schreiben (18) jedes Codeworts (7-12) des zweiten Satzes in ein jedem einzelnen Codewort nach einer vorbestimmten Zuordnungsvorschrift zugeordnetes Segment, falls das jeweilige Codewort in das Segment paßt, wobei jedem Codewort des zweiten Satzes aufgrund der vorbestimmten Zuordnungsvorschrift ein unterschiedliches Segment zugeordnet ist;
b2) falls nur ein Teil (7a) des jeweiligen Codeworts (7) in das zugeordnete Segment paßt, Schreiben des Teils (7a) des jeweiligen Codeworts (7) des zweiten Satzes in das zugeordnete Segment (1) und Speichern des Rests (7b) des Codeworts (7) oder, falls das zugeordnete Segment voll ist, Speichern des ganzen Codeworts (13), dem das volle Segment zugeordnet ist;
b3) Schreiben des gespeicherten Rests (7b) oder des gespeicherten ganzen Codeworts (13), die in dem Schritten b1), b2) nicht in die jeweiligen Segmente paßten, in einen Bereich des Rasters, der nach den Schritten b1) und b2) nicht beschrieben ist, nach einer zweiten vorbestimmten Vorschrift, bis alle Codeworte des zweiten Satzes in das Raster geschrieben sind.

2. Verfahren nach Anspruch 1, bei dem die Codeworte des ersten Satzes in einer Reihenfolge vorliegen, wobei dieselben entsprechend ihrer Reihenfolge in benachbarte Segmente geschrieben werden.

3. Verfahren nach Anspruch 1 oder 2, bei dem die erste vorbestimmte Vorschrift im Schritt a2) folgendermaßen lautet:
i) Schreiben zumindest eines Teils des Rests eines Codeworts des ersten Satzes in das Segment, das dem Segment folgt, in dem der Anfangsabschnitt des Codewortes ist, falls in dem Segment Platz für zumindest einen Teil des Rests ist; und
ii) Durchführen des Schritts (i) für Reste aller weiteren Codeworte des ersten Satzes, falls solche vorhanden sind,
iii) Durchführen der Schritte (i), (ii), wobei immer für jeden Rest um ein Segment weitergegangen wird, bis sämtliche Codeworte des ersten Satzes in den Datenstrom geschrieben sind (31).

4. Verfahren nach einem der vorhergehenden Ansprüche, bei dem die Codeworte des zweiten Satzes in einer Reihenfolge vorliegen und die vorbestimmte Zuordnungsvorschrift das erste Codewort des zweiten Satzes dem Segment zuordnet, in dem der Anfang des ersten Codeworts des ersten Satzes ist, das zweite Codewort des zweiten Satzes dem Segment zuordnet, in dem der Anfang des zweiten Codeworts des ersten Satzes ist, und, falls vorhanden, jedem weiteren Codewort des ersten Satzes das Segment zuordnet, in dem der Anfang des entsprechenden Codeworts des ersten Satzes ist.

5. Verfahren nach einem der vorhergehenden Ansprüche, bei dem die zweite vorbestimmte Vorschrift gleich der ersten vorbestimmten Vorschrift ist.

6. Verfahren nach einem der vorhergehenden Ansprüche, bei dem nach der ersten oder zweiten vorbestimmten Vorschrift ein Codewort des entsprechenden Satzes, das nicht ganz in das zugeordnete Segment paßt, in drei oder mehr Teile zerfällt, wenn in den dem zugeordneten Segment folgenden Segmenten nur soviel Platz ist, daß wieder ein Rest verbleibt.

7. Verfahren nach einem der vorhergehenden Ansprüche, bei dem die Rasterpunkte äquidistant angeordnet sind, wodurch sich gleich lange Segmente bis auf das letzte Segment ergeben, wobei die gleich langen Segmente länger oder gleich lang wie das längste Codewort des ersten Satzes sind, derart, daß jedes Codewort des ersten Satzes in das entsprechende Segment paßt.

8. Verfahren nach einem der vorhergehenden Ansprüche, bei dem die Codeworte des ersten Satzes ausgehend von den jeweils ersten Rasterpunkten der Segmente in einer ersten Schreibrichtung geschrieben werden, und bei dem die Codeworte des zweiten Satzes ausgehend von den jeweils zweiten Rasterpunkten der Segmente in einer der ersten Schreibrichtung entgegengesetzten zweiten Schreibrichtung geschrieben werden.

9. Verfahren nach Anspruch 8, bei dem ein dritter Satz von Codeworten vorhanden ist, wobei die dritten Codeworte wieder in der ersten Schreibrichtung in das Raster geschrieben werden, nachdem alle Codeworte des zweiten Satzes in das Raster geschrieben sind.

10. Verfahren nach einem der vorhergehenden Ansprüche, bei dem die Codeworte Huffman-Codeworte sind.

11. Verfahren nach einem der vorhergehenden Ansprüche, bei dem die Codeworte Informationssymbole darstellen und Codeworte des ersten Satzes bedeutsamere Informationssymbole darstellen als Codeworte des zweiten Satzes oder weiterer Sätze.

12. Verfahren nach Anspruch 11 bei dem die Informationssymbole Spektralwerte eines Audiosignals sind und Codeworte des ersten Satzes psychoakustisch bedeutsame Spektralwerte darstellen, die vor einer Fehlerfortpflanzung aufgrund eines Übertragungsfehlers in dem Datenstrom zu schützen sind.

13. Verfahren nach einem der vorhergehenden Ansprüche, bei dem die Länge des erzeugten Datenstroms gleich der Summe der Länge der Codeworte variabler Länge ist.

14. Verfahren nach einem der vorhergehenden Ansprüche, bei dem mehr als zwei Sätze von Codeworten vorhanden sind, das ferner folgenden Schritt aufweist:
Durchführen der Schritte b1), b2) und b3) für die Codeworte der weiteren Sätze von Codeworten, wobei die zweite vorbestimmte Vorschrift gleich der zweiten vorbestimmten Vorschrift des Schritts b2) entspricht, und wobei die vorbestimmte zuordnungsvorschrift der vorbestimmten Zuordnungsvorschrift des Schritts b1) entspricht.

15. Verfahren zum Lesen eines Datenstroms aus Codeworten variabler Länge, wobei der Datenstrom Codeworte einer Mehrzahl von Sätzen von Codeworten aufweist, wobei für den Datenstrom (38) ein Raster festgelegt ist, das Rasterpunkte (41, 42) aufweist, wobei zwei benachbarte Rasterpunkte (41, 42) ein Segment (40) definieren, wobei der Datenstrom zumindest zwei Segmente aufweist, mit folgenden Schritten:
a) Extrahieren der Codeworte des ersten Satzes aus dem Datenstrom (38) durch folgende Teilschritte:
a1) für jedes Segment, Springen zu einem Rasterpunkt und Lesen eines dort beginnenden Codewortes;
a2) falls das an einem Rasterpunkt beginnende Codewort am Ende des Segments nicht zu Ende ist, Speichern des gelesenen Abschnitts des Codeworts; und
a3) Ermitteln des Rests des Codeworts auf der Basis einer ersten vorbestimmten Vorschrift, die bei der Erzeugung des Datenstroms verwendet wurde;
**gekennzeichnet durch** folgenden Schritt:
b) Extrahieren der Codeworte des zweiten Satzes von Codeworten aus dem nach dem Schritt a) verbleibenden Datenstrom (50) **durch** folgende Teilschritte:
b1) für jedes verbleibende Segment, Springen an einen Rasterpunkt des Segments auf der Basis einer vorbestimmten Zuordnungsvorschrift, die bei der Erzeugung des Datenstroms verwendet wurde, und Lesen des dort beginnenden Codeworts, um die Codeworte des zweiten Satzes zu erhalten,
b2) falls ein Codewort des zweiten Satzes an dem Ende eines entsprechenden Segments nicht zu Ende ist, Speichern des gelesenen Abschnitts des Codeworts des zweiten Satzes;
b3) Ermitteln des Rests des Codeworts bzw. des an einem Rasterpunkt nicht vorhanden Codeworts auf der Basis einer zweiten vorbestimmten Vorschrift, die bei der Erzeugung des Datenstroms verwendet wurde.

16. Verfahren nach Anspruch 15, bei dem der Datenstrom mehr als zwei Sätze von Codeworten aufweist, das ferner folgenden Schritt aufweist:
Extrahieren der Codeworte des dritten Satzes durch wiederholen der Schritte b1), b2) und b3), wobei die zweite vorbestimmte Vorschrift gleich der zweiten vorbestimmten Vorschrift des Schritt b3) ist, und wobei die Zuordnungsvorschrift gleich der Zuordnungsvorschrift des Schritts b1) ist.

17. Verfahren nach Anspruch 15 oder 16, bei dem die Zuordnungsvorschrift, die beim Erzeugen des Datenstroms verwendet wurde, ein erstes Codewort des zweiten Satzes einem Segment zuordnet, in dem das erste Codewort des ersten Satzes beginnt, wobei in dem Schritt b1) an den ersten Rasterpunkt (41) gesprungen wird, um das erste Codewort des zweiten Satzes zu erhalten, an den zweiten Rasterpunkt (42) gesprungen wird, um das zweite Codewort des zweiten Satzes zu erhalten, usw., wobei, wenn an dem ersten Rasterpunkt (41) kein oder nur ein Teil eines Codeworts des zweiten Satzes beginnt, zunächst von allen Rasterpunkten aus gelesen wird, bevor ein fehlendes Codeworts bzw. ein fehlender Teil eines Codeworts auf der Basis der zweiten vorbestimmten Vorschrift ermittelt wird.

18. Verfahren nach einem der Ansprüche 15 bis 17, bei dem die erste vorbestimmte Vorschrift im Schritt a3) folgendermaßen lautet:
für jeden gespeicherten Abschnitt eines gelesenen Codeworts, springen zu dem nächsten Rasterpunkt in dem nach dem Schritt a1) verbleibenden Datenstrom, um den Rest des Codeworts zu ermitteln,
falls ein Codewort bis zum Ende gelesen werden kann, Verbinden des zu Ende gelesenen Codeworts mit dem gespeicherten Abschnitt, um das Codewort des ersten Satzes vollständig zu erhalten, sonst, Speichern eines eventuell gelesenen Abschnitts und Wiederholen des Schritts des Springens zu dem nächsten Rasterpunkt, bis alle Codeworte des ersten Satzes vorliegen.

19. Verfahren nach einem der vorhergehenden Ansprüche, bei dem so viele Codeworte in dem ersten Satz von Codeworten sind, wie der Datenstrom Segmente aufweist, und bei dem die Anzahl der Codeworte in dem bzw. den anderen Sätzen gleich oder kleiner als die Anzahl der Codeworte in dem ersten Satz ist, derart, daß sämtliche Codeworte des ersten Satzes an Rasterpunkte geschrieben werden.

20. Vorrichtung (10) zum Erzeugen eines Datenstroms aus Codeworten variabler Länge, die in einer Mehrzahl von Sätzen von Codeworten unterteilt sind, wobei für den Datenstrom ein Raster mit Rasterpunkten vorliegt, wobei zwei benachbarte Rasterpunkte (41, 42) ein Segment (40) definieren, wobei das Raster eine Mehrzahl von Segmenten aufweist, mit folgenden Merkmalen:
a) einer Einrichtung (16) zum Schreiben der Codeworte (1-6) des ersten Satzes, derart, daß Anfänge der Codeworte an Rasterpunkten unterschiedlicher Segmente liegen, wobei die Einrichtung (16) angeordnet ist, um
falls ein Codewort länger als ein Segment ist, den Rest des Codeworts in einen Bereich des Rasters, der nach dem Schritt a1) nicht beschrieben ist, entsprechend einer ersten vorbestimmten Vorschrift zu schreiben, bis alle Codeworte des ersten Satzes in das Raster geschrieben sind;
**gekennzeichnet durch**
b) eine Einrichtung (18) zum Schreiben jedes Codeworts des zweiten Satzes in ein jedem einzelnen Codewort nach einer vorbestimmten Zuordnungsvorschrift zugeordnetes Segment, falls das jeweilige Codewort in das Segment paßt, wobei jedem Codewort des zweiten Satzes aufgrund der vorbestimmten Zuordnungsvorschrift ein unterschiedliches Segment zugeordnet ist, wobei die Einrichtung (18) angeordnet ist, um
falls nur ein Teil des jeweiligen Codeworts in das zugeordnete Segment paßt, den Teil (7a) des jeweiligen Codeworts (7) des zweiten Satzes in das zugeordnete Segment (1) zu schreiben, und den Rest des Codeworts (7b) zu speichern, oder falls das zugeordnete segment voll ist, das ganze Codewort (13), dem das volle Segment zugeordnet ist, zu speichern;
den gespeicherten Rest (7b) oder das gespeicherte ganze Codewort (13), die in dem Schritten b1), b2) nicht in die jeweiligen Segmente paßten, in einen Bereich des Rasters, der nach den Schritten b1) und b2) nicht beschrieben ist, nach einer zweiten vorbestimmten Vorschrift zu schreiben, bis alle Codeworte des zweiten Satzes in das Raster geschrieben sind.

21. Vorrichtung (22) zum Lesen eines Datenstroms aus Codeworten variabler Länge, wobei der Datenstrom Codeworte einer Mehrzahl von Sätzen von Codeworten aufweist, wobei für den Datenstrom (38) ein Raster festgelegt ist, das Rasterpunkte (41, 42) aufweist, wobei zwei benachbarte Rasterpunkte (41, 42) ein Segment (40) definieren, wobei der Datenstrom zumindest zwei Segmente aufweist, mit folgenden Merkmalen:
a) einer Einrichtung (28) zum Extrahieren der Codeworte des ersten Satzes aus dem Datenstrom (38), die angeordnet ist, um
für jedes Segment zu einem Rasterpunkt zu springen und ein dort beginnendes Codewort zu lesen;
falls das an einem Rasterpunkt beginnende Codewort am Ende des Segments nicht zu Ende ist, den gelesenen Abschnitt des Codeworts zu speichern;
den Rest des Codeworts auf der Basis einer ersten vorbestimmten Vorschrift, die bei der Erzeugung des Datenstroms verwendet wurde, zu ermitteln;
**gekennzeichnet durch**
b) eine Einrichtung (30) zum Extrahieren der Codeworte des zweiten Satzes von Codeworten aus dem nach dem Schritt a) verbleibenden Datenstrom (50), die angeordnet ist, um
für jedes verbleibende Segment an einen Rasterpunkt des Segments auf der Basis einer vorbestimmten Zuordnungsvorschrift, die bei der Erzeugung des Datenstroms verwendet wurde, zu springen und das dort beginnende Codewort zu lesen, um die Codeworte des zweiten Satzes zu erhalten,
falls ein Codewort des zweiten Satzes an dem Ende eines entsprechenden Segments nicht zu Ende ist, den gelesenen Abschnitt des Codeworts des zweiten Satzes zu speichern;
den Rest des Codeworts bzw. des an einem Rasterpunkt nicht vorhanden Codeworts auf der Basis einer zweiten vorbestimmten Vorschrift, die bei der Erzeugung des Datenstroms verwendet wurde, zu ermitteln.

## Claims

1. Method for producing a data stream of code words of variable lengths which are divided up into a plurality of sets of code words, a raster having raster points existing for the data stream, two adjacent raster points (41, 42) defining one segment (40), and the raster comprising a plurality of segments, the method including the following steps:
a1) writing (16) the code words (1-6) of the first set such that starts of the code words are at raster points of different segments; and
a2) in case a code word is longer than a segment, writing the remainder of the code words into an area of the raster which is not written onto after step a1), pursuant to a first predetermined regulation, until all code words of the first set have been written into the raster;
**characterized by** the following steps:
b1) in case the respective code word fits in the segment, writing (18) each code word (7-12) of the second set into a segment which is assigned to each individual code word pursuant to a predetermined assignment rule, wherein each code word of the second set is assigned a different segment due to the predetermined assignment rule;
b2) in case only a part (7a) of the respective code word (7) fits in the assigned segment or, writing the part (7a) of the respective code word (7) of the second set into the assigned segment (1) and storing the remainder (7b) of the code word (7), or, in case the assigned segment is full, storing the entire code word (13) which is assigned the full segment;
b3) writing the stored remainder (7b) or the stored entire code word (13), which did not fit in the respective segments in steps b1), b2), into an area of the raster which is not written onto after steps b1) and b2), pursuant to a second predetermined regulation, until all code words of the second set have been written into the raster.

2. Method as claimed in claim 1, in which the code words of the first set are present in an order, wherein these are written into adjacent segments in accordance with their order.

3. Method as claimed in claim 1 or 2, in which the first predetermined regulation in step a2) is as follows:
i) writing at least a part of the remainder of a code word of the first set into the segment following the segment in which the starting section of the code word is present, in case there is room, in the segment, for at least part of the remainder; and
ii) conducting step (i) for remainders of all further code words of the first set in case such code words are present; and
iii) conducting steps (i), (ii), wherein one proceeds by one segment for each remainder until all code words of the first set have been written into the data stream (31).

4. Method as claimed by any of the preceding claims, in which the code words of the second set are present in an order and the predetermined assignment rule assigns the first code word of the second set to that segment in which the start of the first code word of the first set is present, assigns the second code word of the second set to that segment in which the start of the second code word of the first set is present and, in case existent, assigns each further code word of the first set that segment in which the start of the corresponding code word of the first set is present.

5. Method as claimed by any of the preceding claims, in which the second predetermined regulation is equal to the first predetermined regulation.

6. Method as claimed by any of the preceding claims, in which, pursuant to the first or second predetermined regulation, a code word of the corresponding set which does not entirely fit into the assigned segment falls in three or more parts in case there is only so much room in the segments following the assigned segment that, again, a remainder remains.

7. Method as claimed by any of the preceding claims, in which the raster points are arranged equally spaced apart, whereby equally long segments, except for the final segment, result, wherein the equally long segments are longer than or as long as the longest code word of the first set, such that each code word of the first set fits in the corresponding segment.

8. Method as claimed by any of the preceding claims, in which the code words of the first set are written in a first writing direction starting from the first raster points of the segments, respectively, and in which the code words of the second set are written in a second writing direction opposite to the first writing direction, starting from the second raster points of the segments, respectively.

9. Method as claimed in claim 8, in which a third set of code words is present, wherein the third code words are, again, written into the raster in the first writing direction after all code words of the second set have been written into the raster.

10. Method as claimed by any of the preceding claims, in which the code words are Huffman code words.

11. Method as claimed by any of the preceding claims, in which the code words represent information symbols and in which code words of the first set represent more significant information symbols than code words of the second set or of further sets.

12. Method as claimed in claim 11, in which the information symbols are spectral values of an audio signal and code words of the first set are spectral values significant from a psycho-acoustic point of view, which are to be protected from any error propagation due to a transmission error in the data stream.

13. Method as claimed by one of the preceding claims, in which the length of the data stream produced is equal to the sum of the lengths of the code words of variable lengths.

14. Method as claimed by any of the preceding claims, in which more than two sets of code words are present and which further comprises the following step:
conducting steps b1), b2) and b3) for the code words of the further sets of code words, wherein the second predetermined regulation corresponds to the second predetermined regulation of step b2) and wherein the predetermined assignment rule corresponds to the predetermined assignment rule of step b1).

15. Method for reading a data stream of code words of variable lengths, wherein the data stream comprises code words of a plurality of sets of code words, wherein a raster is specified for the data stream (38), which comprises raster points (41, 42) in which two adjacent raster points (41, 42) define a segment (40), wherein the data stream comprises at least two segments, which method includes the following steps:
a) extracting the code words of the first set from the data stream (38) by the following individual steps:
a1) for each segment, jumping to a raster point and reading a code word starting there;
a2) in case the code word which starts at a raster point is not finished at the end of the segment, storing the read section of the code word, and
a3) determining the remainder of the code word on the basis of a first predetermined regulation which was used when producing the data stream;
**characterized by** the following step:
b) extracting the code words of the second set of code words from the data stream (50) remaining after step (a) by the following individual steps:
b1) for each remaining segment, jumping to a raster point of the segment on the basis of a predetermined assignment rule which was used when producing the data stream, and reading the code word starting there, in order to obtain the code words of the second set;
b2) in case a code word of the second set is not finished at the end of a corresponding segment, storing the read section of the code word of the second set;
b3) determining the remainder of the code word or the code word not present at a raster point, on the basis of a second predetermined regulation which was used when producing the data stream.

16. Method as claimed in claim 15, in which the data stream comprises more than two sets of code words, which method further includes the following step:
extracting the code words of the third set by repeating steps b1), b2) and b3), wherein the second predetermined regulation is equal to the second predetermined regulation of step b3) and wherein the assignment rule is equal to the assignment rule of step b1).

17. Method as claimed in claim 15 or 16, in which the assignment rule, which was used when producing the data stream, assigns a first code word of the second set to a segment in which the first code word of the first set starts, wherein, in step b1), one jumps to the first raster point (41) in order to obtain the first code word of the second set, one jumps to the second raster point (42) in order to obtain the second code word of the second set, etc., wherein, in case no or only part of a code word of the second set starts at the first raster point (41), one initially reads starting from all raster points, before a missing code word or a missing part of a code word is determined on the basis of the second predetermined regulation.

18. Method as claimed by one of claims 15 to 17, in which the first predetermined regulation in step a3) is as follows:
for each stored section of a read code word, jumping to the next raster point in the data stream which remains after step a1) in order to determine the remainder of the code word;
in case a code word can be read to the end, connecting the code word which has been read to the end with the stored section in order to obtain the code word of the first set completely, otherwise storing a section which may have been read and repeating the step of jumping to the next raster point, until all code words of the first set are present.

19. Method as claimed by any of the preceding claims, in which there are as many code words in the first set of code words as there are segments in the data stream, and in which the number of code words in the other set or sets is equal to or smaller than the number of code words in the first set, such that all code words of the first set are written to raster points.

20. Apparatus (10) for producing a data stream of code words of variable lengths which are divided up into a plurality of sets of code words, in which a raster having raster points is present for the data stream, in which two adjacent raster points (41, 42) define a segment (40), the raster comprising a plurality of segments, the apparatus comprising:
a) a device (16) for writing the code words (1-6) of the first set such that starts of code words are present at raster points of different segments, wherein the device (16) is arranged so as
in case a code word is longer than a segment, to write the remainder of the code word into an area of the raster which is not written onto after step a1), pursuant to a first predetermined regulation, until all code words of the first set have been written into the raster; **characterized by**
b) a device (18) for writing each code word of the second set into a segment which is assigned to each individual code word pursuant to a predetermined assignment rule, wherein each code word of the second set is assigned, due to the predetermined assignment rule, a different segment, in case the respective code word fits in the segment, wherein the device (18) is arranged so as
in case only part of the respective code word fits in the assigned segment, to write the part (7a) of the respective code word (7) of the second set into the assigned segment (1) and to store the remainder of the code word (7b) or, in case the assigned segment is full, to store the entire code word (13) which is assigned the full segment;
to write the stored remainder (7b) and the stored entire code word (13), which did not fit in the respective segments in steps b1), b2), into an area of the raster which is not written onto after steps b1) and b), pursuant to a second predetermined regulation, until all code words of the second set have been written into the raster.

21. Apparatus (22) for reading a data stream of code words of variable lengths, in which the data stream comprises code words of a plurality of sets of code words, wherein, for the data stream (38), a raster is specified which comprises raster points (41, 42), wherein two adjacent raster points (41, 42) define a segment (40), wherein the data stream comprises at least two segments, which apparatus comprises the following:
a) a device (28) for extracting the code words of the first set from the data stream (38), which is arranged so as to
for each segment, to jump to a raster point and to read a code word starting there;
in case the code word starting at a raster point is not finished at the end of the segment, to store the read section of the code word;
to determine the remainder of the code word on the basis of a first predetermined regulation which was used when producing the data stream; **characterized by**
b) a device (30) for extracting the code words of the second set of code words from the data stream (50) which remains after step a), which is arranged so as
to jump, for each remaining segment, to a raster point of the segment on the basis of a predetermined assignment rule which was used when producing the data stream and to read the code word starting there in order to obtain the code words of the second set,
in case a code word of the second set is not finished at the end of a corresponding segment, to store the read section of the code word of the second set;
to determine the remainder of the code word or the code word not present at a raster point on the basis of a second predetermined regulation which was used when producing the data stream.

## Revendications

1. Procédé pour générer un flux de données constitué de mots de code de longueur variable subdivisés en une pluralité de jeux de mots de code, pour le flux de données étant présente une trame à points de trame, deux points de trame adjacents (41, 42) définissant un segment (40), la trame présentant une pluralité de segments, aux étapes suivantes consistant à :
a1) écrire (16) les mots de code (1 à 6) du premier jeu de sorte que les débuts des mots de code se trouvent à des points de trame de différents segments ; et
a2) lorsqu'un mot de code est plus long qu'un segment, écrire le reste du mot de code dans une zone de la trame ne contenant pas d'écriture après l'étape a1), selon une première prescription prédéterminée, jusqu'à ce que tous les mots de code du premier jeu soient écrits dans la trame ;
**caractérisé par** les étapes suivantes consistant à :
b1) écrire (18) chaque mot de code (7 à 12) du second jeu dans un segment associé à chaque mot de code individuel, selon une prescription d'association prédéterminée, si le mot de code respectif entre dans le segment, à chaque mot de code du second jeu étant associé, sur base de la prescription d'association prédéterminée, un segment différent ;
b2) lorsque seule une partie (7a) du mot de code respectif (7) entre dans le segment associé, écrire la partie (7a) du mot de code respectif (7) du second jeu dans le segment associé (1) et mémoriser le reste (7b) du mot de code (7) ou, lorsque le segment associé est rempli, mémoriser tout le mot de code (13) auquel est associé le segment rempli ;
b3) écrire le reste (7b) mémorisé ou le mot de code entier (13) mémorisé, qui, aux étapes b1), b2), n'entraient pas dans les segments respectifs, dans une zone de la trame ne contenant pas d'écriture après les étapes b1) et b2), selon une seconde prescription prédéterminée, jusqu'à ce que tous les mots de code du second jeu soient écrits dans la trame.

2. Procédé selon la revendication 1, dans lequel les mots de code du premier jeu se présentent selon un ordre de succession, ceux-ci étant écrits dans des segments adjacents dans leur ordre de succession.

3. Procédé selon la revendication 1 ou 2, dans lequel la première prescription prédéterminée à l'étape a2) est la suivante :
i) écrire au moins une partie du reste d'un mot de code du premier jeu dans le segment suivant le segment dans lequel se trouve le tronçon initial du mode de code, s'il y a de la place dans le segment pour au moins une partie du reste ; et
ii) effectuer l'étape (i) pour les restes de tous les autres mots de code du premier jeu, si ceux-ci existent,
iii) effectuer les étapes (i), (ii), en avançant toujours d'un segment pour chaque reste, jusqu'à ce que tous les mots de code du premier jeu soient écrits dans le flux de données (31).

4. Procédé selon l'une des revendications précédentes, dans lequel les mots de code du second jeu se présentent selon un ordre de succession et la prescription d'association prédéterminée associe le premier mot de code du second jeu au segment dans lequel se trouve le début du premier mot de code du premier jeu, associe le second mot de code du second jeu au segment dans lequel se trouve le début du second mot de code du premier jeu, et, le cas échéant, associe à chaque autre mot de code du premier jeu le segment dans lequel se trouve le début du mot de code correspondant du premier jeu.

5. Procédé selon l'une des revendications précédentes, dans lequel la seconde prescription prédéterminée est identique à la première prescription prédéterminée.

6. Procédé selon l'une des revendications précédentes, dans lequel, selon la première ou la seconde prescription prédéterminée, un mot de code du jeu correspondant n'entrant pas dans le segment associé se décompose en trois parties ou plus lorsque la place dans les segments suivant le segment associé est telle qu'il y a à nouveau un reste.

7. Procédé selon l'une des revendications précédentes, dans lequel les points de trame sont disposés équidistants, d'où résultent des segments de même longueur, à l'exception du dernier segment, les segments de même longueur étant plus longs ou de même longueur que le mot de code le plus long du premier jeu, de sorte que chaque mot de code du premier jeu entre dans le segment correspondant.

8. Procédé selon l'une des revendications précédentes, dans lequel chacun des mots de code du premier jeu est écrit, partant des premiers points de trame respectifs des segments, dans une première direction d'écriture et dans lequel les mots de code du second jeu sont écrits, partant des seconds points de trame respectifs des segments, dans une seconde direction d'écriture opposée à la première direction d'écriture.

9. Procédé selon la revendication 8, dans lequel est présent un troisième jeu de mots de code, les troisièmes mots de code étant à nouveau écrits dans la trame dans la première direction d'écriture, après que tous les mots de code du second jeu ont été écrits dans la trame.

10. Procédé selon l'une des revendications précédentes, dans lequel les mots de code sont des mots de code de Huffman.

11. Procédé selon l'une des revendications précédentes, dans lequel les mots de code représentent des symboles d'information et les mots de code du premier jeu représentent des symboles d'information plus importants que les mots de code du second jeu ou de jeux ultérieurs.

12. Procédé selon la revendication 11, dans lequel les symboles d'information sont des valeurs spectrales d'un signal audio et les mots de code du premier jeu représentent des valeurs spectrales psychoacoustiquement importantes devant être protégées contre une propagation d'erreur par suite d'une erreur de transmission dans le flux de données.

13. Procédé selon l'une des revendications précédentes, dans lequel la longueur du flux de données généré est égale à la somme de la longueur des mots de code de longueur variable.

14. Procédé selon l'une des revendications précédentes, dans lequel sont présents plus de deux jeux de mots de code, présentant, par ailleurs, l'étape suivante consistant à :
effectuer les étapes b1), b2) et b3) pour les mots de code des autres jeux de mots de code, la seconde prescription prédéterminée correspondant à la seconde prescription prédéterminée de l'étape b2) et la prescription d'association prédéterminée correspondant à la prescription d'association prédéterminée de l'étape b1).

15. Procédé pour lire un flux de données constitué de mots de code de longueur variable, le flux de données présentant des mots de code constitués d'une pluralité de jeux de mots de code, pour le flux de données (38) étant établie une trame présentant des points de trame (41, 42), deux points de trame (41, 42) adjacents définissant un segment (40), le flux de données présentant au moins deux segments, aux étapes suivantes consistant à :
a) extraire du flux de données (38) les mots de code du premier jeu, par les étapes partielles suivantes :
a1) pour chaque segment, sauter à un point de trame et lire un mot de code qui y commence ;
a2) si un mot de code commençant à un point de trame n'est pas terminé à la fin du segment, mémoriser le tronçon lu du mot de code ; et
a3) déterminer le reste du mot de code sur base d'une première prescription prédéterminée utilisée lors de la génération du flux de données ;
**caractérisé par** l'étape suivante consistant à :
b) extraire les mots de code du second jeu de mots de code du flux de données (50) restant après l'étape a), par les étapes suivantes consistant à :
b1) pour chaque segment restant, sauter à un point de trame du segment, sur base d'une prescription d'association prédéterminée utilisée lors de la génération du flux de données, pour obtenir les mots de code du second jeu ;
b2) si un mot de code du second jeu n'est pas terminé à la fin d'un segment correspondant, mémoriser le tronçon lu du mot de code du second jeu ;
b3) déterminer le reste du mot de code ou le mode de code non présent à un point de trame sur base d'une seconde prescription prédéterminée utilisée lors de la génération du flux de données.

16. Procédé selon la revendication 15, dans lequel le flux de données présente plus de deux jeux de mots de code, présentant, par ailleurs, l'étape suivante consistant à:
extraire les mots de code du troisième jeu en répétant les étapes b1), b2) et b3), la seconde prescription prédéterminée étant identique à la seconde prescription prédéterminée de l'étape b2) et la prescription d'association étant identique à la prescription d'association de l'étape b1).

17. Procédé selon la revendication 15 ou 16, dans lequel la prescription d'association utilisée lors de la génération du flux de données associe un premier mot de code du second jeu à un segment dans lequel commence le premier mot de code du premier jeu, tout en sautant, à l'étape b1), au premier point de trame (41), pour obtenir le premier mot de code du second jeu, au second point de trame (42), pour obtenir le second mot de code du second jeu, etc., et, lorsqu'au premier point de trame (41) ne commence pas de mot de code ou qu'une partie d'un mot de code du second jeu, en lisant tout d'abord à partir de tous les points de trame, avant de déterminer, sur base d'une seconde prescription prédéterminée, un mot de code manquant ou une partie manquante d'un mot de code.

18. Procédé selon l'une des revendications 15 à 17, dans lequel la première prescription prédéterminée à l'étape a3) est la suivante :
pour chaque tronçon mémorisé d'un mot de code lu, sauter au point de trame suivant dans le flux de données restant après l'étape a1), pour déterminer le reste du mot de code,
si un mode de code peut être lu jusqu'à la fin, assembler le mot de code lu jusqu'à la fin avec le tronçon mémorisé, pour obtenir le mot de code complet du premier jeu, sinon, mémoriser un tronçon éventuellement lu et répéter l'étape de saut au point de trame suivant, jusqu'à ce que tous les mots de code du premier jeu soient présents.

19. Procédé selon l'une des revendications précédentes, dans lequel il y a autant de mots de code dans le premier jeu de mots de code que de segments dans le flux de données et dans lequel le nombre de mots de code dans le ou les autres jeux est égal ou inférieur au nombre de mots de codes dans le premier jeu, de sorte que tous les mots de code du premier jeu soient écrits à des points de trame.

20. Dispositif (10) pour générer un flux de données constitué de mots de code de longueur variable subdivisés en une pluralité de jeux de mots de code, pour le flux de données étant présente une trame à points de trame, deux points de trame adjacents (41, 42) définissant un segment (40), la trame présentant une pluralité de segments, aux caractéristiques suivantes :
a) un dispositif (16) destiné à écrire les mots de code (1 à 6) du premier jeu de sorte que les débuts des mots de code se trouvent à des points de trame de différents segments, le dispositif (16) étant disposé de manière à
lorsqu'un mot de code est plus long qu'un segment, écrire le reste du mot de code dans une zone de la trame ne contenant pas d'écriture après l'étape a1), selon une première prescription prédéterminée, jusqu'à ce que tous les mots de code du premier jeu soient écrits dans la trame ;
**caractérisé par** :
b) un dispositif (18) destiné à écrire chaque mot de code du second jeu dans un segment associé à chaque mot de code individuel selon une prescription d'association prédéterminée, si le mot de code respectif entre dans le segment, à chaque mot de code du second jeu étant associé, sur base de la prescription d'association prédéterminée, un segment différent, le dispositif (18) étant disposé de manière à
lorsque seule une partie du mot de code respectif entre dans le segment associé, écrire la partie (7a) du mot de code respectif (7) du second jeu dans le segment associé (1) et mémoriser le reste du mot de code (7b) ou, lorsque le segment associé est rempli, mémoriser tout le mot de code (13) auquel est associé le segment rempli ;
écrire le reste (7b) mémorisé ou le mot de code entier (13) mémorisé, qui, aux étapes b1), b2), n'entraient pas dans les segments respectifs, dans une zone de la trame ne contenant pas d'écriture après les étapes b1) et b2), selon une seconde prescription prédéterminée, jusqu'à ce que tous les mots de code du second jeu soient écrits dans la trame.

21. Dispositif (22) pour lire un flux de données constitué de mots de code de longueur variable, le flux de données présentant des mots de code constitués d'une pluralité de jeux de mots de code, pour le flux de données (38) étant établie une trame présentant des points de trame (41, 42), deux points de trame (41, 42) adjacents définissant un segment (40), le flux de données présentant au moins deux segments, aux caractéristiques suivantes :
a) un dispositif (28) destiné à extraire du flux de données (38) les mots de code du premier jeu, lequel est disposé de manière à :
pour chaque segment, sauter à un point de trame et lire un mot de code qui y commence ;
si le mot de code commençant à un point de trame n'est pas terminé à la fin du segment, mémoriser le tronçon lu du mot de code ;
déterminer le reste du mot de code sur base d'une première prescription prédéterminée utilisée lors de la génération du flux de données ;
**caractérisé par** :
b) un dispositif (30) destiné à extraire les mots de code du second jeu de mots de code du flux de données (50) restant après l'étape a), lequel est disposé de manière à
pour chaque segment restant, sauter à un point de trame du segment, sur base d'une prescription d'association prédéterminée utilisée lors de la génération du flux de données, et lire le mot de code qui y commence, pour obtenir les mots de code du second jeu ;
si un mot de code du second jeu n'est pas terminé à la fin d'un segment correspondant, mémoriser le tronçon lu du mot de code du second jeu ;
déterminer le reste du mot de code ou le mode de code non présent à un point de trame sur base d'une seconde prescription prédéterminée utilisée lors de la génération du flux de données.
